# EUROPEAN PATENT APPLICATION

(11) **EP 4 823 076 A1**
(43) Date of publication of application: **14.10.2026**
(21) Application number: 24906067.4
(22) Date of filing: 03.12.2024
(51) Int. Cl.: H04L 67/5651, H04B 7/06

(54) **DATA TRANSMISSION METHOD AND COMMUNICATION APPARATUS**

(30) Priority: 22.12.2023 CN 202311793539
(71) Applicant: Huawei Technologies Co., Ltd., Shenzhen, Guangdong 518129 (CN)
(72) Inventor: TANG, Zihan, Shenzhen, Guangdong 518129 (CN); MA, Mengyao, Shenzhen, Guangdong 518129 (CN); LIU, Kai, Shenzhen, Guangdong 518129 (CN); YAN, Min, Shenzhen, Guangdong 518129 (CN)
(74) Representative: Pfenning, Meinig & Partner mbB
(86) International application number: PCT/CN2024/136269
(87) International publication number: WO 2025/130582

(57) **Abstract**

A data transmission method and a communication apparatus are provided. Based on a hierarchical structure of air interface native data, a hierarchical data compression solution may be used, that is, a plurality of projection basis groups may be used to perform level-by-level projection compression on data, so that the hierarchical structure in data redundancy can be fully used. This helps improve data compression performance and reduce transmission overheads. In addition, a projection basis group may be associated with a geographical region or an identity of a communication device. When the communication device does not move out of a geographical region corresponding to the projection basis or does not leave a communication device group corresponding to the projection basis, the projection basis does not need to be updated, thereby further reducing transmission overheads.

## Description

This application claims priority to Chinese Patent Application No. 202311793539.2, filed with the China National Intellectual Property Administration on December 22, 2023 and entitled "DATA TRANSMISSION METHOD AND COMMUNICATION APPARATUS", which is incorporated herein by reference in its entirety.

### TECHNICAL FIELD

This application relates to the communication field, and more specifically, to a data transmission method and a communication apparatus.

### BACKGROUND

Future wireless communication networks involve a variety of new scenarios and corresponding new transmission requirements, thereby generating a large amount of air interface (radio access network, RAN) native data. The air interface native data may include integrated sensing and communication data, artificial intelligence (artificial intelligence, AI) model data, channel state information (channel state information, CSI) data of a multi-antenna system, and the like. The air interface native data has high dimensionality and a large data volume, and interaction and transmission of the air interface native data occupy a large quantity of air interface resources.

Generally, the air interface native data may be compressed by using data compression technologies. In this way, on a premise that a distortion requirement or a task accuracy requirement is met, occupation of air interface resources can be reduced, and transmission overheads can be reduced. However, with current data compression methods, transmission overheads caused by the air interface native data are still large. Therefore, how to reduce transmission overheads caused by air interface native data becomes an urgent problem to be resolved.

### SUMMARY

This application provides a data transmission method and a communication apparatus, to reduce transmission overheads caused by air interface native data.

According to a first aspect, a data transmission method is provided. The method may be performed by a first communication device. Unless otherwise specified, the "first communication device" may be the first communication device, or may be an apparatus that can support the first communication device in implementing a function of the first communication device. Optionally, the first communication device may be a terminal device or an access network device.

The method includes: obtaining data to be sent to a second communication device, where the data to be sent to the second communication device includes first data; obtaining a first projection basis group and a second projection basis group, where a projection basis in the first projection basis group corresponds to a first range, a projection basis in the second projection basis group corresponds to a second range, the second range is a sub-range of the first range, and the first data corresponds to the second range; compressing the first data based on the first projection basis group, to obtain a first projection result and a first residual; compressing the first residual based on the second projection basis group, to obtain a second projection result; and sending compressed data to the second communication device, where the compressed data includes the first projection result and the second projection result.

According to the foregoing method, a hierarchical data compression solution may be used, that is, a plurality of projection basis groups may be used to perform level-by-level projection compression on the data, so that the hierarchical structure in data redundancy can be fully used. This helps improve data compression performance and reduce transmission overheads. In addition, in the foregoing method, the projection basis group may be associated with a range. When a communication device is not out of a range corresponding to a projection basis, the projection basis does not need to be updated, helping further reduce transmission overheads.

With reference to the first aspect, in some implementations, the first range is a first region, and the second range is a second region; or the first range corresponds to a communication device group, and the second range corresponds to a part of communication devices in the communication device group.

With reference to the first aspect or any implementation of the first aspect, in some other implementations, the method further includes: sending first information and/or second information to the second communication device, where the first information indicates one or more projection bases that are in the first projection basis group and that are used to compress the first data, and the second information indicates one or more projection bases that are in the second projection basis group and that are used to compress the first residual.

Based on the foregoing implementation, when performing data compression, the first communication device may use a part of projection bases in the first projection basis group and/or a part of projection bases in the second projection basis group, so that data compression is more flexible.

With reference to the first aspect or any implementation of the first aspect, in some other implementations, the compressed data further includes a second residual, and the second residual is a residual obtained when the first residual is compressed based on the second projection basis group or a subsequent processing result of the residual obtained when the first residual is compressed based on the second projection basis group.

Based on the foregoing implementation, the first communication device may send the residual obtained through projection compression to the second communication device, to help the second communication device recover original data.

With reference to the first aspect or any implementation of the first aspect, in some other implementations, the compressed data further includes a third projection result. The method further includes: obtaining a third projection basis group, where a projection basis in the third projection basis group corresponds to a third range, and the third range is a sub-range of the second range. Compressing the first residual based on the second projection basis group to obtain the second projection result includes: compressing the first residual based on the second projection basis group to obtain the second projection result and a third residual. The method further includes: compressing the third residual based on the third projection basis group to obtain the third projection result.

Based on the foregoing implementation, the first communication device may perform more than two levels of projection compression on the data to be sent to the second communication device, so that the hierarchical structure in data redundancy can be fully used, and better projection compression is performed on the to-be-sent data, thereby helping reduce transmission overheads.

With reference to the first aspect or any implementation of the first aspect, in some other implementations, the method further includes: determining the first projection basis group based on second data corresponding to the first range; and/or determining the second projection basis group based on third data corresponding to the second range.

Based on the foregoing implementation, each projector used for projection compression may be obtained through calculation or learning by a data transmit end device.

With reference to the first aspect or any implementation of the first aspect, in some other implementations, determining the second projection basis group based on the third data corresponding to the second range includes: compressing the third data based on the first projection basis group to obtain a second residual; and determining the second projection basis group based on the second residual.

Based on the foregoing implementation, determining of a projection basis corresponding to a sub-range depends on a projection basis corresponding to a range to which the sub-range belongs, so that correlation between data in sub-ranges can be better represented.

With reference to the first aspect or any implementation of the first aspect, in some other implementations, the method further includes: sending the first projection basis group and/or the second projection basis group to the second communication device.

With reference to the first aspect or any implementation of the first aspect, in some other implementations, the first range is the first region, and the second range is the second region. Sending the first projection basis group and/or the second projection basis group to the second communication device includes: after the second communication device enters the first region, sending the first projection basis group to the second communication device; and/or after the second communication device enters the second region, sending the second projection basis group to the second communication device.

Based on the foregoing implementation, the first communication device may configure a projection basis group corresponding to a region for the second communication device when the second communication device enters or is handed over to the region.

With reference to the first aspect or any implementation of the first aspect, in some other implementations, the first range is the first region, and the second range is the second region. Sending the first projection basis group and/or the second projection basis group to the second communication device includes: sending third information and/or fourth information to the second communication device. The third information indicates a first set, the first set includes a plurality of projection basis groups, the plurality of projection basis groups respectively correspond to a plurality of sub-regions of a third region, and the plurality of sub-regions of the third region include the first region. The fourth information indicates a second set, the second set includes a plurality of projection basis groups, the plurality of projection basis groups respectively correspond to a plurality of sub-regions of the first region, and the plurality of sub-regions of the first region include the second region.

Based on the foregoing implementation, the first communication device may send, to the second communication device, a projection basis group corresponding to a location of the second communication device and a projection basis group corresponding to an adjacent location of the location of the second communication device. In this way, when the second communication device moves in regions corresponding to these projection basis groups, the first communication device does not need to update the projection basis group for the second communication device. This helps reduce signaling overheads caused by repeatedly sending the projection basis group.

With reference to the first aspect or any implementation of the first aspect, in some other implementations, the method further includes: sending fifth information and/or sixth information to the second communication device, where the fifth information indicates that the first projection result corresponds to the first projection basis group, and the sixth information indicates that the second projection result corresponds to the second projection basis group.

Based on the foregoing implementation, when the first communication device configures a plurality of projection basis groups for the second communication device at a time, the first communication device may indicate, to the second communication device, a projection basis group used for the compressed data, so that the second communication device selects the same projection basis group for decompression. This helps correctly decompress the data.

With reference to the first aspect or any implementation of the first aspect, in some other implementations, the method further includes: sending seventh information and/or eighth information to the second communication device, where the seventh information indicates a correspondence between the plurality of projection basis groups included in the first set and the plurality of sub-regions of the third region, and the eighth information indicates a correspondence between the plurality of projection basis groups included in the second set and the plurality of sub-regions of the first region.

Based on the foregoing implementation, when the first communication device configures a plurality of projection basis groups for the second communication device at a time, the first communication device may indicate, to the second communication device, a correspondence between the plurality of projection basis groups and a plurality of regions. In this way, the second communication device may select, based on the location information and the correspondence, a projection basis group corresponding to a region in which the second communication device is located, so that the first communication device and the second communication device may select a same projection basis group for compression and decompression. This helps correctly decompress the data.

With reference to the first aspect or any implementation of the first aspect, in some other implementations, the first range is the first region, and the second range is the second region. Obtaining the first projection basis group and the second projection basis group includes: obtaining location information of the first communication device or the second communication device; and obtaining, based on the location information, the first projection basis group corresponding to the first region in which the first communication device or the second communication device is located and the second projection basis group corresponding to the second region in which the first communication device or the second communication device is located.

With reference to the first aspect or any implementation of the first aspect, in some other implementations, the first range is the first region, and the second range is the second region. The data to be sent to the second communication device further includes fourth data, the fourth data corresponds to a fourth region, the fourth region is a sub-region of the first region, and the compressed data further includes a fourth projection result corresponding to the fourth data. The method further includes: obtaining a fourth projection basis group, where a projection basis in the fourth projection basis group corresponds to the fourth region. Compressing the first data based on the first projection basis group to obtain the first projection result and the first residual includes: compressing the first data and the fourth data based on the first projection basis group to obtain the first projection result and the first residual, where the first residual includes a first sub-part and a second sub-part. Compressing the first residual based on the second projection basis group to obtain the second projection result includes: compressing the first sub-part of the first residual based on the second projection basis group to obtain the second projection result. The method further includes: compressing the second sub-part of the first residual based on the fourth projection basis group to obtain the fourth projection result.

When the second communication device is located at a boundary between the second region and the fourth region, a part of the data to be sent to the second communication device may correspond to the second region, and the other part may correspond to the fourth region. In this case, based on the foregoing implementation, the first communication device may separately perform projection compression on corresponding data based on the second projection basis group corresponding to the second region and the fourth projection basis group corresponding to the fourth region, and a used projection basis group is more appropriate, helping improve data compression performance.

With reference to the first aspect or any implementation of the first aspect, in some other implementations, the method further includes: sending ninth information to the second communication device, where the ninth information indicates a location of the first data and/or a location of the fourth data in the data to be sent to the second communication device.

Based on the foregoing implementation, the first communication device may further indicate, to the second communication device, the location of the first data and/or the location of the fourth data in the data to be sent to the second communication device, to help the second communication device recover an original data sequence, thereby improving data transmission efficiency.

With reference to the first aspect or any implementation of the first aspect, in some other implementations, the first range is a first region, and the second range is a second region. Obtaining the first projection basis group and the second projection basis group includes: receiving the first projection basis group and the second projection basis group from the second communication device.

Based on the foregoing implementation, each projector used for projection compression may be obtained through calculation or learning by a data receive end device.

With reference to the first aspect or any implementation of the first aspect, in some other implementations, tenth information and/or eleventh information are/is received from the second communication device, where the tenth information indicates a correspondence between the first projection basis group and the first region, and the eleventh information indicates a correspondence between the second projection basis group and the second region.

With reference to the first aspect or any implementation of the first aspect, in some other implementations, the first region is a cell.

With reference to the first aspect or any implementation of the first aspect, in some other implementations, the first range corresponds to a communication device group, and the second range corresponds to a part of communication devices in the communication device group. Obtaining the first projection basis group and the second projection basis group includes: obtaining, based on the second communication device belonging to the communication device group, the first projection basis group corresponding to the communication device group; and obtaining, based on the second communication device belonging to the part of the communication devices, the second projection basis group corresponding to the part of the communication devices.

With reference to the first aspect or any implementation of the first aspect, in some other implementations, the first range corresponds to the communication device group, and the second range corresponds to the second communication device in the communication device group. Sending the first projection basis group and/or the second projection basis group to a communication device in the communication device group includes: multicasting the first projection basis group to communication devices in the communication device group, and/or unicasting the second projection basis group to the second communication device.

Based on the foregoing implementation, the first communication device may multicast the first projection basis group to the communication device in the communication device group, thereby helping reduce signaling overheads caused by sending the projection basis group.

According to a second aspect, a data transmission method is provided. The method may be performed by a second communication device. Unless otherwise specified, the "second communication device" may be the second communication device, or may be an apparatus that can support the second communication device in implementing a function of the second communication device. Optionally, the second communication device may be a terminal device or an access network device.

For terms or features that are in the second aspect or the implementations of the second aspect and that are the same as those in the first aspect or the implementations of the first aspect, refer to the first aspect or the implementations of the first aspect. For technical effects of the second aspect or the implementations of the second aspect, refer to technical effects of the first aspect or the implementations of the first aspect. Details are not described again in the second aspect.

The method includes: receiving compressed data from a first communication device, where the compressed data includes a first projection result and a second projection result; obtaining a first projection basis group and a second projection basis group, where a projection basis in the first projection basis group corresponds to a first range, a projection basis in the second projection basis group corresponds to a second range, and the second range is a sub-range of the first range; performing decompression based on the second projection basis group and the second projection result to obtain a first residual; and performing decompression based on the first projection basis group and the first residual to obtain the first data.

With reference to the second aspect, in some implementations, the first range is a first region, and the second range is a second region; or the first range corresponds to a communication device group, and the second range corresponds to a part of communication devices in the communication device group.

With reference to the second aspect or any implementation of the second aspect, in some other implementations, the method further includes: receiving first information and/or second information from the first communication device, where the first information indicates one or more projection bases that are in the first projection basis group and that are used to compress the first data, and the second information indicates one or more projection bases that are in the second projection basis group and that are used to compress the first residual.

With reference to the second aspect or any implementation of the second aspect, in some other implementations, the compressed data further includes a second residual. Performing decompression based on the second projection basis group and the second projection result to obtain the first residual includes: performing decompression based on the second projection basis group, the second projection result, and the second residual to obtain the first residual.

With reference to the second aspect or any implementation of the second aspect, in some other implementations, the compressed data further includes a third projection result. The method further includes: obtaining a third projection basis group, where a projection basis in the third projection basis group corresponds to a third range, and the third range is a sub-range of the second range; and performing decompression based on the third projection basis group and the third projection result to obtain a third residual. Performing decompression based on the second projection basis group and the second projection result to obtain the first residual includes: performing decompression based on the second projection basis group, the second projection result, and the third residual to obtain the first residual.

With reference to the second aspect or any implementation of the second aspect, in some other implementations, obtaining the first projection basis group and the second projection basis group includes: receiving the first projection basis group and the second projection basis group from the first communication device.

With reference to the second aspect or any implementation of the second aspect, in some other implementations, the first range is the first region, and the second range is the second region. Receiving the first projection basis group and the second projection basis group from the first communication device includes: after the second communication device enters the first region, receiving the first projection basis group from the first communication device; and after the second communication device enters the second region, receiving the second projection basis group from the first communication device.

With reference to the second aspect or any implementation of the second aspect, in some other implementations, the first range corresponds to the communication device group, and the second range corresponds to the second communication device in the communication device group. Receiving the first projection basis group and the second projection basis group from the first communication device includes: receiving the first projection basis group that is multicast by the first communication device; and receiving the second projection basis group that is unicast by the first communication device.

With reference to the second aspect or any implementation of the second aspect, in some other implementations, the first range is the first region, and the second range is the second region. The method further includes: receiving third information and fifth information from the first communication device, where the third information indicates a first set, the first set includes a plurality of projection basis groups, the plurality of projection basis groups respectively correspond to a plurality of sub-regions of a third region, the plurality of sub-regions of the third region include the first region, and the fifth information indicates that the first projection result corresponds to the first projection basis group; and obtaining the first projection basis group includes: obtaining the first projection basis group from the first set based on the third information. In addition/Alternatively, the method further includes: receiving fourth information and sixth information from the first communication device, where the fourth information indicates a second set, the second set includes a plurality of projection basis groups, the plurality of projection basis groups respectively correspond to a plurality of sub-regions of the first region, the plurality of sub-regions of the first region include the second region, and the sixth information indicates that the second projection result corresponds to the second projection basis group; and obtaining the second projection basis group includes: obtaining the second projection basis group from the second set based on the fourth information.

With reference to the second aspect or any implementation of the second aspect, in some other implementations, the first range is the first region, and the second range is the second region. The method further includes: obtaining location information of the first communication device or the second communication device. The method further includes: receiving third information and seventh information from the second communication device, where the third information indicates a first set, the first set includes a plurality of projection basis groups, the plurality of projection basis groups respectively correspond to a plurality of sub-regions of a third region, the plurality of sub-regions of the third region include the first region, and the seventh information indicates a correspondence between the plurality of projection basis groups included in the first set and the plurality of sub-regions of the third region; and obtaining the first projection basis group includes: obtaining, from the first set based on the location information, the third information, and the seventh information, the first projection basis group corresponding to the first region in which the first communication device or the second communication device is located. In addition/Alternatively, the method further includes: receiving fourth information and eighth information from the second communication device, where the fourth information indicates a second set, the second set includes a plurality of projection basis groups, the plurality of projection basis groups respectively correspond to a plurality of sub-regions of the first region, the plurality of sub-regions of the first region include the second region, and the eighth information indicates a correspondence between the plurality of projection basis groups included in the second set and the plurality of sub-regions of the first region; and obtaining the second projection basis group includes: obtaining, from the second set based on the location information, the fourth information, and the eighth information, the second projection basis group corresponding to the second region in which the first communication device or the second communication device is located.

With reference to the second aspect or any implementation of the second aspect, in some other implementations, the first range is the first region, and the second range is the second region. The compressed data further includes a fourth projection result. Performing decompression based on the second projection basis group and the second projection result to obtain the first residual includes: performing decompression based on the second projection basis group and the second projection result to obtain a first sub-part of the first residual. The method further includes: obtaining a fourth projection basis group, where a projection basis in the fourth projection basis group corresponds to a fourth region, and the fourth region is a sub-region of the first region; and performing decompression based on the fourth projection basis group and the fourth projection result to obtain a second sub-part of the first residual. Performing decompression based on the first projection basis group and the first residual to obtain the first data includes: performing decompression based on the first projection basis group, the first sub-part of the first residual, and the second sub-part of the first residual to obtain the first data.

With reference to the second aspect or any implementation of the second aspect, in some other implementations, the method further includes: receiving ninth information from the first communication device, where the ninth information indicates a location of the first data and/or a location of the fourth data in the data to be sent to the second communication device.

With reference to the second aspect or any implementation of the second aspect, in some other implementations, the first range is the first region, and the second range is the second region. Obtaining the first projection basis group and the second projection basis group includes: determining the first projection basis group based on second data corresponding to the first region; and determining the second projection basis group based on third data corresponding to the second region.

With reference to the second aspect or any implementation of the second aspect, in some other implementations, the method further includes: sending tenth information and/or eleventh information to the first communication device, where the tenth information indicates a correspondence between the first projection basis group and the first region, and the eleventh information indicates a correspondence between the second projection basis group and the second region.

With reference to the second aspect or any implementation of the second aspect, in some other implementations, the first region is a cell.

According to a third aspect, a communication apparatus is provided. The apparatus is configured to perform the method provided in any one of the foregoing aspects or the implementations of the foregoing aspects. Specifically, the apparatus may include a unit and/or a module configured to perform the method provided in any one of the foregoing aspects or the implementations of the foregoing aspects, for example, a processing unit and/or a transceiver unit.

In an implementation, the apparatus is a first communication device or a second communication device. When the apparatus is the first communication device or the second communication device, the transceiver unit may be a transceiver, an input/output interface, or a communication interface; and the processing unit may be at least one processor. Optionally, the transceiver is a transceiver circuit. Optionally, the input/output interface is an input/output circuit.

In another implementation, the apparatus is a chip, a chip system, or a circuit used in the first communication device or the second communication device. When the apparatus is a chip, a chip system, or a circuit used in the first communication device or the second communication device, the transceiver unit may be an input/output interface, an interface circuit, an output circuit, an input circuit, a pin, a related circuit, or the like on the chip, the chip system, or the circuit, and the processing unit may be at least one processor, processing circuit, logic circuit, or the like.

According to a fourth aspect, a communication apparatus is provided. The apparatus includes: a memory, configured to store a program; and at least one processor, configured to execute a computer program or instructions stored in the memory, to perform the method provided in any one of the foregoing aspects or the implementations of the foregoing aspects.

In an implementation, the apparatus is a first communication device or a second communication device.

In another implementation, the apparatus is a chip, a chip system, or a circuit used in the first communication device or the second communication device.

According to a fifth aspect, a communication apparatus is provided. The apparatus includes at least one processor and a communication interface. The at least one processor is configured to obtain, through the communication interface, a computer program or instructions stored in a memory, to perform the method provided in any one of the foregoing aspects or the implementations of the foregoing aspects. The communication interface may be implemented by hardware or software.

In an implementation, the apparatus further includes the memory.

According to a sixth aspect, a processor is provided, and is configured to perform the methods provided in the foregoing aspects.

Unless otherwise specified, or if operations such as sending and obtaining/receiving related to the processor do not conflict with actual functions or internal logic of the operations in related descriptions, the operations may be understood as operations such as outputting, receiving, and inputting of the processor, or may be understood as sending and receiving operations performed by a radio frequency circuit and an antenna. This is not limited in this application.

According to a seventh aspect, a computer-readable storage medium is provided. The computer-readable medium stores program code to be executed by a device. The program code is used to perform the method provided in any one of the foregoing aspects or the implementations of the foregoing aspects.

According to an eighth aspect, a computer program product including instructions is provided. When the computer program product runs on a computer, the computer is enabled to perform the method provided in any one of the foregoing aspects or the implementations of the foregoing aspects.

According to a ninth aspect, a chip is provided. The chip includes a processor and a communication interface. The processor reads, through the communication interface, instructions stored in a memory, to perform the method provided in any one of the foregoing aspects or the implementations of the foregoing aspects. The communication interface may be implemented by hardware or software.

Optionally, in an implementation, the chip further includes the memory. The memory stores a computer program or the instructions. The processor is configured to execute the computer program or the instructions stored in the memory. When the computer program or the instructions are executed, the processor is configured to perform the method provided in any one of the foregoing aspects or the implementations of the foregoing aspects.

When the method provided in this application is performed by the chip, a quantity of chips that specifically implement the method in this application is not limited in this application. For example, the method may be performed by one chip, or may be performed by two or more chips. In addition, when two or more chips implement the method in this application, a chip vendor is not limited. The chips may be from a same vendor or from different vendors.

According to a tenth aspect, a communication system is provided, including at least one of the following devices: a communication apparatus configured to perform the method provided in the first aspect or the implementations of the first aspect, or a communication apparatus configured to perform the method provided in the second aspect or the implementations of the second aspect.

According to an eleventh aspect, a computer program is provided. When the computer program is run on a computer, the method provided in any one of the foregoing aspects or the implementations of the foregoing aspects is performed.

### BRIEF DESCRIPTION OF DRAWINGS

FIG. 1 is a diagram of an architecture of a communication system to which an embodiment of this application is applied.
FIG. 2 is a diagram of an overall procedure of air interface native data compression and transmission;
FIG. 3 is a diagram of a radio frequency map (radio frequency map, RF map) grid and an RF map data matrix;
FIG. 4 is a diagram of a low rank matrix approximation (low rank matrix approximation, LRMA) principle;
FIG. 5 is a schematic flowchart of a data transmission method 500 according to an embodiment of this application;
FIG. 6 is a diagram of an overall procedure of data compression based on two layers of projection bases;
FIG. 7 is a diagram of determining a cell common projection basis;
FIG. 8 is a diagram of a correspondence between a region-specific projection basis and a sub-region;
FIG. 9 is an example of an implementation for determining a region-specific projection basis;
FIG. 10 is another example of an implementation for determining a region-specific projection basis;
FIG. 11 is a diagram of a moving path of user equipment;
FIG. 12 is an example of configuration of a cell common projection basis and a region-specific projection basis and data transmission;
FIG. 13 is another example of configuration of a cell common projection basis and a region-specific projection basis and data transmission;
FIG. 14 is another diagram of a moving path of user equipment;
FIG. 15 is another example of configuration of a cell common projection basis and a region-specific projection basis and data transmission;
FIG. 16 is another diagram of a moving path of user equipment;
FIG. 17 is another example of configuration of a cell common projection basis and a region-specific projection basis and data transmission;
FIG. 18 is an example of data grouping;
FIG. 19 is another diagram of an overall procedure of data compression based on two layers of projection bases;
FIG. 20 is an example of configuration of a common projection basis and a user region-specific projection basis and data transmission;
FIG. 21 is a diagram of a simulation scenario;
FIG. 22 is a diagram of comparison of rate distortion (rate distortion, RD) performance of compression;
FIG. 23 is a diagram of a structure of a possible apparatus according to an embodiment of this application;
FIG. 24 is a diagram of another structure of a possible apparatus according to an embodiment of this application; and
FIG. 25 is a diagram of a chip system according to an embodiment of this application.

### DESCRIPTION OF EMBODIMENTS

For ease of understanding embodiments of this application, before embodiments of this application are described, the following descriptions are first provided.

An "indication" includes a direct indication (also referred to as an explicit indication) and an implicit indication. Directly indicating information A means including the information A. Implicitly indicating the information A means indicating the information A by directly indicating information B and based on a correspondence between the information A and the information B. The correspondence between the information A and the information B may be predefined, prestored, pre-burned, or preconfigured. That information C is used to determine information D includes that the information D is determined only based on the information C, and also includes that the information D is determined based on the information C and other information. In addition, that the information C is used to determine the information D may further include an indirect determining case. For example, the information D is determined based on information E, and the information E is determined based on the information C. That "a network element A sends information A to a network element B" may be understood as meaning that a destination end of the information A or an intermediate network element in a transmission path between the network element A and the destination end is the network element B, and may include directly or indirectly sending information to the network element B. That "a network element B receives information A from a network element A" may be understood as meaning that a source end of the information A or an intermediate network element in a transmission path between the network element B and the source end is the network element A, and may include directly or indirectly receiving information from the network element A. Information may undergo necessary processing, for example, a format change, between a source end for sending the information and a destination end. However, the destination end may understand valid information from the source end.

Various numerical numbers such as first and second are merely used for differentiation for ease of description, and are not used to limit the scope of embodiments of this application, for example, to distinguish between different messages and different information. A related "protocol" may be a standard protocol in the communication field, for example, may include a long term evolution (long term evolution, LTE) protocol, a new radio (new radio, NR) protocol, and a related protocol applied to a future communication system. This is not limited in this application.

Words such as "example", "for example", "for instance", and "in an (another) example" represent giving an example, an illustration, or a description. Any embodiment or design scheme described as an "example" in this application should not be explained as being more preferred or having more advantages than another embodiment or design scheme.

The terms "include", "have", and their variants all mean "include but are not limited to", unless otherwise specifically emphasized in another manner. "A plurality of" means two or more than two. "And/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects. At least one of the following items (pieces) or a similar expression thereof indicates any combination of these items, including a single item (piece) or any combination of a plurality of items (pieces). For example, at least one item (piece) of a, b, and c may indicate a, b, c, a and b, a and c, b and c, or a, b, and c. Each of a, b, and c may be in a singular form or a plural form.

Descriptions such as "when...", "in a case of...", "in response to", and "if" all mean that a device performs corresponding processing in a specific objective situation, where time is not limited, the device is not necessarily required to perform a determining action during implementation, and this does not mean that there is another limitation.

In addition, the network architecture and the service scenario described in embodiments of this application are intended to describe the technical solutions in embodiments of this application more clearly, and do not constitute a limitation on the technical solutions provided in embodiments of this application. A person of ordinary skill in the art may know that, with the evolution of the network architecture and the emergence of new service scenarios, the technical solutions provided in embodiments of this application are also applicable to similar technical problems.

The following describes communication systems to which embodiments of this application may be applied.

Embodiments of this application may be applied to a cellular wireless communication system, for example, an LTE system, a frequency division duplex (frequency division duplex, FDD) system, a time division duplex (time division duplex, TDD) system, a universal mobile telecommunications system (universal mobile telecommunications system, UMTS), a worldwide interoperability for microwave access (worldwide interoperability for microwave access, WiMAX) communication system, a 5G system, an NR system, or a future communication system. The 5G mobile communication system in this application includes a non-standalone (non-standalone, NSA) 5G mobile communication system or a standalone (standalone, SA) 5G mobile communication system. The communication system may alternatively be a public land mobile network (public land mobile network, PLMN), a device-to-device (device-to-device, D2D) communication system, a machine-to-machine (machine-to-machine, M2M) communication system, an internet of things (internet of Things, IoT) communication system, a vehicle-to-everything (vehicle-to-everything, V2X) communication system, an uncrewed aerial vehicle (uncrewed aerial vehicle, UAV) communication system, or another communication system. The communication system may alternatively be a short-range wireless communication system like a wireless fidelity (wireless fidelity, Wi-Fi) communication system or an ultra-wideband (ultra-wideband, UWB) communication system.

A device in the communication system may send a signal to another device or receive a signal from another device. The signal may include information, signaling, data, or the like. The device may alternatively be replaced with an entity, a network entity, a communication device, a communication module, a node, a communication node, or the like. In this application, the device is used as an example for description. For example, the communication system may include at least one terminal device and at least one access network device. The access network device may send a downlink signal to the terminal device, and/or the terminal device may send an uplink signal to the access network device.

The communication system applicable to embodiments of this application may include one or more transmit end devices and one or more receive end devices. Optionally, one of the transmit end device and the receive end device may be a terminal device, and the other may be an access network device. Optionally, both the transmit end device and the receive end device may be terminal devices. Optionally, both the transmit end device and the receive end device may be access network devices. For ease of description, a transmit end device of data is referred to as a first communication device, and a receive end device of the data is referred to as a second communication device below.

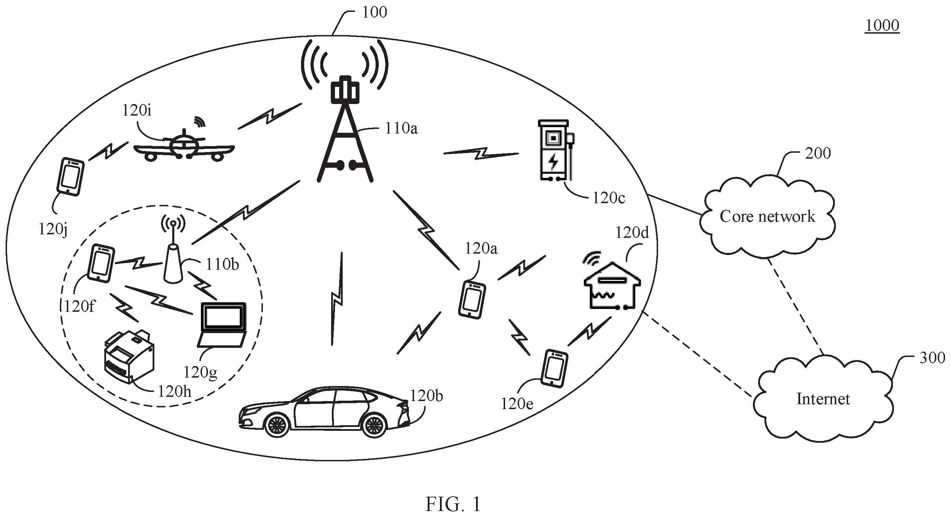

For example, FIG. 1 is a diagram of an architecture of a communication system 1000 to which an embodiment of this application is applied. As shown in FIG. 1, the communication system includes a radio access network 100 and a core network 200. In a possible implementation, the communication system 1000 may further include an internet 300. The RAN 100 may include at least one radio access network device (for example, 110a and 110b in FIG. 1), and may further include at least one terminal device (for example, 120a to 120j in FIG. 1). The terminal device is connected to the radio access network device in a wireless manner, and the radio access network device is connected to a core network in a wireless or wired manner. A core network device and the radio access network device may be independent and different physical devices, or functions of the core network device and logical functions of the radio access network device may be integrated into a same physical device, or some functions of the core network device and some functions of the radio access network device may be integrated into one physical device. Terminal devices may be connected to each other in a wired or wireless manner, and radio access network devices may be connected to each other in a wired or wireless manner. FIG. 1 is merely a diagram. The communication system may further include other network devices, for example, a wireless relay device and a wireless backhaul device, which are not shown in FIG. 1.

The terminal device in the communication system 1000 may also be referred to as a terminal, user equipment (user equipment, UE), a mobile station, a mobile terminal, or the like. The terminal device may be widely used in various scenarios, for example, D2D, V2X, MTC, IoT, virtual reality, augmented reality, industrial control, self-driving, telemedicine, a smart grid, smart furniture, a smart office, a smart wearable, smart transportation, and a smart city. The terminal device may be a mobile phone, a tablet computer, a computer with a wireless transceiver function, a wearable device, a vehicle, an uncrewed aerial vehicle, a helicopter, an airplane, a ship, a robot, a robotic arm, a smart home device, or the like. A device form of the terminal device is not limited in embodiments of this application.

The radio access network 100 may be a cellular system related to the 3rd generation partnership project (3rd generation partnership project, 3GPP), for example, a 4G mobile communication system, a 5G mobile communication system, or a future-oriented evolved system. The radio access network 100 may alternatively be an open access network (open RAN, O-RAN, or ORAN) or a cloud radio access network (cloud radio access network, CRAN). Alternatively, the radio access network 100 may be a communication system integrating the foregoing two or more systems.

The radio access network device sometimes may also be referred to as a radio access network node, a radio access network entity, an access node, or the like, and is a part of a communication system, to help the terminal device implement radio access. A plurality of radio access network devices in the communication system 1000 may be nodes of a same type or nodes of different types.

In a possible scenario, the radio access network device may be a base station (base station), an evolved NodeB (evolved NodeB, eNodeB), an access point (access point, AP), a transmission reception point (transmission reception point, TRP), a next generation NodeB (next generation NodeB, gNB), a base station in a future mobile communication system, or the like. The RAN node may be a macro base station (for example, 110a in FIG. 1), a micro base station, or an indoor base station (for example, 110b in FIG. 1), a relay node or a donor node, or a radio controller in a CRAN scenario. For example, the radio access network node may alternatively be a server, a wearable device, a vehicle, a vehicle-mounted device, or the like. For example, an access network device in a V2X technology may be a road side unit (road side unit, RSU).

In another possible scenario, a plurality of radio access network devices cooperate to assist the terminal device in implementing radio access, and different radio access network devices each implement a part of functions of a base station. For example, the radio access network device may be a central unit (central unit, CU), a distributed unit (distributed unit, DU), a CU-control plane (control plane, CP), a CU-user plane (user plane, UP), a radio unit (radio unit, RU), or the like. The CU and the DU may be separately disposed, or may be included in a same network element, for example, a baseband unit (baseband unit, BBU). The RU may be included in a radio frequency device or a radio frequency unit, for example, included in a remote radio unit (remote radio unit, RRU), a radio frequency unit (radio frequency unit, RFU), an active antenna unit (active antenna unit, AAU), or a remote radio head (remote radio head, RRH).

In different systems, the CU, the DU, or the RU may have different names, but a person skilled in the art may understand meanings thereof. For example, in an ORAN system, the CU may also be referred to as an open CU (open-CU, O-CU), the DU may also be referred to as an open DU (open-DU, O-DU), and the RU may also be referred to as an open RU (open-RU, O-RU). Any one of the CU, the DU, and the RU may be implemented by using a software module, a hardware module or a combination of a software module and a hardware module.

A specific technology and a specific device form that are used by the radio access network device are not limited in embodiments of this application. For ease of description, the access network device is used as an abbreviation of the radio access network device, and the base station is used as an example of the radio access network device.

The base station and the terminal device may be fixed or movable. The base station and the terminal device may be deployed on land, including an indoor or outdoor scenario and a handheld or vehicle-mounted scenario, or may be deployed on water, or may be deployed on an airplane, a balloon, and an artificial satellite. Application scenarios of the base station and the terminal device are not limited in embodiments of this application.

Roles of the base station and the terminal device may be relative. For example, a helicopter or an uncrewed aerial vehicle 120i in FIG. 1 may be configured as a mobile base station, and for those terminal devices 120j accessing the radio access network 100 by 120i, the terminal device 120i is a base station. However, for the base station 110a, 120i is a terminal device. In other words, communication between 110a and 120i is performed based on a radio air interface protocol. Certainly, 110a and 120i may alternatively communicate with each other by using an interface protocol between base stations. In this case, compared with 110a, 120i is also a base station. Therefore, the base station and the terminal device may be collectively referred to as a communication apparatus, 110a and 110b in FIG. 1 may be referred to as a communication apparatus having a function of a base station, and 120a to 120j in FIG. 1 may be referred to as a communication apparatus having a function of a terminal device.

Communication between a base station and a terminal device, between base stations, or between terminal devices may be performed by using a licensed spectrum, or may be performed by using an unlicensed spectrum, or may be performed by using both a licensed spectrum and an unlicensed spectrum. Communication may be performed by using a spectrum below 6 gigahertz (gigahertz, GHz), or may be performed by using a spectrum above 6 GHz, or may be performed by using both a spectrum below 6 GHz and a spectrum above 6 GHz. A spectrum resource for wireless communication is not limited in embodiments of this application.

Unless otherwise specified, an apparatus configured to implement a function of a terminal device or an access network device in this application may be the terminal device or the access network device, or may be an apparatus that can support the terminal device or the access network device in implementing a function of the terminal device or the access network device, for example, a circuit, a chip system, or a chip. Specifically, the apparatus may be a system on a chip (system on a chip, SoC) or a modem (Modem). The apparatus may be mounted in the terminal device or the access network device. In embodiments of this application, the chip system may include a chip, or may include a chip and another discrete device.

It should be understood that the foregoing network architecture is merely an example for description, and the network architecture applicable to embodiments of this application is not limited thereto. Any network architecture that can implement functions of the foregoing network elements is applicable to embodiments of this application.

It should be further understood that the foregoing names are defined merely for ease of distinguishing between different functions, and should not constitute any limitation on this application. This application does not exclude a possibility of using other names in another future network.

For ease of understanding embodiments of this application, several concepts or terms in embodiments of this application are briefly described below.

The concepts or the terms described below are described based on concepts or terms specified in a protocol. However, this does not mean that embodiments of this application can be applied only to a current existing system, and the concepts or the terms in embodiments of this application can be applied to a future system. In addition, specific names of the concepts or the terms (for example, concepts or terms related to functional descriptions) may be adjusted with development of the future system.

### 1. Air interface native data

The air interface native data may include integrated sensing and communication data, artificial intelligence (artificial intelligence, AI) model data, channel state information (channel state information, CSI) data of a multi-antenna system, and the like. Generally, the air interface native data has various forms of redundancy. For example, a large amount of data in a sensed original signal has little impact on a subsequent task, and discarding the data can greatly reduce an amount of transmitted data. For another example, sensed point cloud data has a correlation in time and space, and a channel matrix has a strong correlation in frequency domain and spatial angle domain.

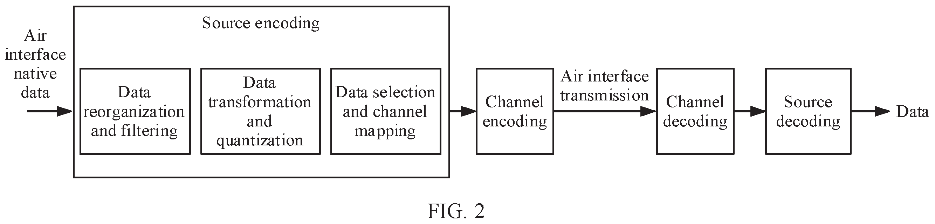

FIG. 2 is a diagram of an overall procedure of air interface native data compression and transmission.

As shown in FIG. 2, air interface native data is transmitted from a source to a destination through source encoding, channel encoding, air interface transmission, channel decoding, source decoding, and the like. Source encoding, channel encoding, and the like are performed on a transmit end device of the air interface native data, and channel decoding, source decoding, and the like are performed on a receive end device of the air interface native data.

The air interface native data compression may occur before channel encoding, for example, during source encoding. Source encoding may include processing such as channel encoding, data reorganizing and filtering (data reorganizing and filtering), data transform and quantization (data transform and quantization), and data selection and channel mapping (data selection and channel mapping). The air interface native data compression may be regarded as a generalized form of data transform.

In addition, the air interface native data compression may alternatively occur at another protocol layer, for example, an application layer. This is not limited in embodiments of this application.

### 2. Radio frequency map (RF map) data

The radio frequency map data may also be referred to as electromagnetic map data. The RF map data is a type of air interface native data related to a geographical location, mainly describes electromagnetic propagation characteristics of an environment, and may be used to assist in communication, positioning, and the like. The RF map data is an important type of native sensing data.

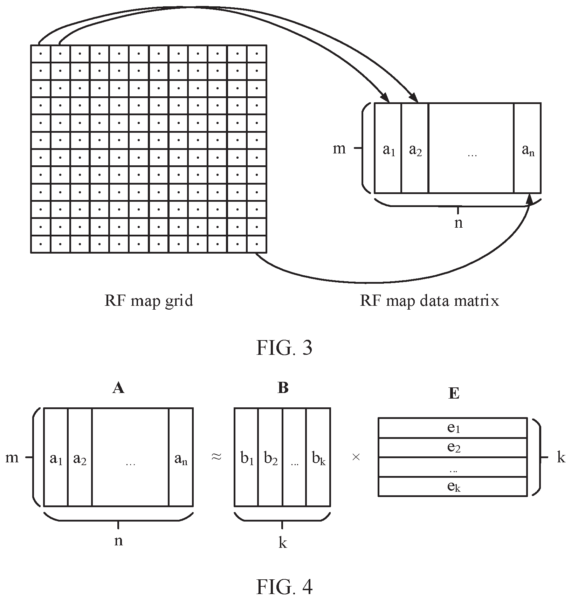

FIG. 3 is a diagram of an RF map grid and an RF map data matrix.

As shown in FIG. 3, a space is divided into a plurality of grids based on a specific resolution, and each grid may be represented by one location point (usually a center point of the grid), and electromagnetic propagation information at each location point is recorded, to obtain an RF map grid. A column in the RF map data matrix corresponds to electromagnetic propagation information recorded in a grid in the RF map grid. For example, an a₁^{th} column in the RF map data matrix whose size is m×n corresponds to electromagnetic propagation information recorded in a 1^{st} grid in the RF map grid, an a₂^{th} column corresponds to electromagnetic propagation information recorded in a 2^{nd} grid in the RF map grid, and an aₙ^{th} column corresponds to electromagnetic propagation information recorded in a last grid in the RF map grid. The RF map data matrix is a summary of electromagnetic propagation information (or part of the information) in all grids of the RF map grid, and is used to describe electromagnetic propagation characteristics of an entire region.

The electromagnetic propagation information may include but is not limited to all or a part of the following information:
(1) multipath information, such as an angle, a delay, or a power;
(2) scaler information, such as a capacity (capacity) and a channel quality indicator (channel quality indicator, CQI);
(3) whether electromagnetic propagation with a base station is line of sight (line of sight, LOS) propagation or non-line of sight (non-line of sight, NLOS) propagation;
(4) a deterministic H matrix; and
(5) geographical location coordinates represented by the grid.

### 3. Low-rank matrix approximation LRMA

The LRMA is a common compression method based on a correlation between data keys, and may be considered as transform domain compression or projection compression. FIG. 4 shows an LRMA principle.

FIG. 4 is a diagram of the LRMA principle. As shown in FIG. 4, through dimension-reduced singular value decomposition (singular value decomposition, SVD), namely, truncated SVD, a matrix A whose size is m×n may be approximately represented by a matrix B and a matrix E. Columns of the matrix B are orthogonal to each other, and a length of each column of the matrix B is a unit length. One column of the matrix B may be considered as a projection basis for projection to one low-dimensional subspace. The matrix E is a projection coefficient or a projection result of the matrix A on a group of projection bases of the matrix B. The EYM (Eckart-Young-Mirsky) theorem can guarantee optimality of the projection basis of the truncated SVD.

The foregoing briefly describes concepts or terms in embodiments of this application, and the following does not provide explanations again.

The air interface native data features a high dimension and a large data amount, and interaction and transmission of the air interface native data occupy a large quantity of air interface resources. Generally, the air interface native data may be compressed by using a data compression technology. In this way, on a premise that a distortion requirement or a task accuracy requirement is met, occupation of air interface resources can be greatly reduced, and transmission overheads can be reduced. However, according to a current data compression method, transmission overheads caused by the air interface native data are still large. Therefore, how to reduce transmission overheads caused by air interface native data becomes an urgent problem to be resolved.

For the foregoing problem, embodiments of this application provide a data transmission method and a communication apparatus, to reduce transmission overheads caused by air interface native data.

Generally, the air interface native data has various forms of redundancy, and mining a redundancy relationship of the air interface native data is one of the keys for data compression. The inventor finds that, in some scenarios, redundancy of air interface native data shows a hierarchical structure. For example, in a single-transmit single-receive scenario, there is a common representation space between data sent by a transmit end device to a receive end device at different moments, that is, data at different moments is correlated and has redundancy. Data at each moment also has an independent representation space, that is, there is redundancy between data at a moment. For another example, when a transmit end device sends data to a plurality of receive end devices, because of a correlation between different receive end devices, there is a common representation space between data of different receive end devices, that is, there is redundancy between data of different receive end devices. Data of each receive end device also has an independent representation space, that is, there is redundancy between data of a single receive end device.

Based on the hierarchical structure of the air interface native data, in this application, a hierarchical data compression solution is used, so that a hierarchical structure in data redundancy can be fully used, thereby reducing transmission overheads while maintaining same compression accuracy as that in an existing data compression solution.

The following describes method embodiments of this application.

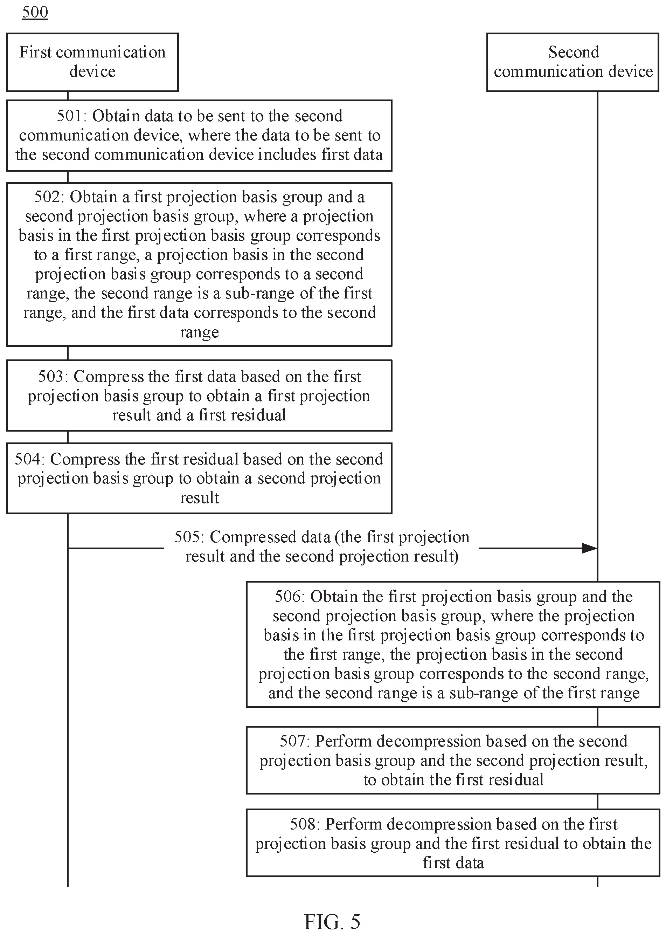

FIG. 5 is a schematic flowchart of a data transmission method 500 according to an embodiment of this application.

The method 500 may be performed by a first communication device and a second communication device. The first communication device is a data transmit end device, a data encoder device, or a data compression device. The second communication device is a data receive end device, a data decoder device, or a data decompression device. Unless otherwise specified, the "first communication device" or the "second communication device" may refer to the first communication device or the second communication device, or may refer to an apparatus that can support the first communication device or the second communication device in implementing a function of the first communication device or the second communication device. For ease of description, the first communication device and the second communication device are uniformly used throughout the following descriptions. Optionally, the first communication device may be a terminal device or an access network device. Optionally, the second communication device may be a terminal device or an access network device.

The method 500 includes at least a part of the following content.

Step 501: The first communication device obtains data to be sent to the second communication device.

The data to be sent to the second communication device includes first data.

That the first communication device obtains the data to be sent to the second communication device may mean that the first communication device reads, from a buffer, the data to be sent to the second communication device. Data stored in the buffer may be collected and processed by the first communication device and then stored, or may be received by the first communication device from another communication apparatus. This is not limited.

Step 502: The first communication device obtains a first projection basis group and a second projection basis group.

In this embodiment of this application, a projection basis group may be associated with a range. In other words, different projection basis groups are applicable to different ranges. Because the projection basis group is associated with the range, the first communication device may obtain, based on a range to which the first communication device or the second communication device belongs, a projection basis group corresponding to the corresponding range, to compress the data to be sent to the second communication device.

The range in this embodiment of this application may refer to various types of ranges. In an example, the range in this embodiment of this application may be a range of a region (for example, a geographical region). For example, different projection basis groups may be applicable to different regions. In this case, the projection basis group is associated with the region. When a projection basis group for data compression or data decompression is selected, selection may be performed based on a region corresponding to the to-be-sent data. In another example, the range in this embodiment of this application may be an applicable communication device range. For example, different projection basis groups may be applicable to different communication device groups. In this case, the projection basis group may be associated with an identity of a data receive end device. When a projection basis group for data compression or data decompression is selected, selection may be performed based on a group in which the data receive end device is located.

Based on a hierarchical structure of air interface native data, in this embodiment of this application, a hierarchical data compression solution may be used, that is, a plurality of projection basis groups may be used to perform level-by-level projection compression on the data. Projection basis groups used for projection compression at different levels correspond to different ranges, and there is a hierarchical structure between the different ranges. For example, two-level projection compression is performed on the data. A projection basis group used for first-level projection compression may correspond to a range A, a projection basis group used for second-level projection compression may correspond to a range B, there is a hierarchical structure between the range A and the range B, and the range B may be a sub-range of the range A. In this case, the projection basis group obtained by the first communication device and used to compress the data to be sent to the second communication device may include projection basis groups corresponding to multi-level projection compression. That the projection basis group corresponds to a range may be understood as meaning that the projection basis group is applicable to projection compression of data in the range.

The following describes embodiments of this application by using two-level projection compression in multi-level projection compression as an example. The two-level projection compression may be any two levels of projection compression in the multi-level projection compression.

For the two-level projection compression, as shown in step 502, the first communication device may obtain the first projection basis group and the second projection basis group. The first projection basis group corresponds to the first-level projection compression, and a projection basis in the first projection basis group corresponds to a first range. The second projection basis group corresponds to the second-level projection compression, a projection basis in the second projection basis group corresponds to a second range, and the second range is a sub-range of the first range. Numbers "first" and "second" in the first-level projection compression and the second-level projection compression herein are merely intended to indicate that the first-level projection compression and the second-level projection compression are projection compression at different levels. That a projection basis in the projection basis group corresponds to a range may be understood as meaning that the projection basis in the projection basis group is used for projection compression of data in the range, the projection basis in the projection basis group is used for projection compression of data of a device in the range, the projection basis in the projection basis group is used for projection compression of data collected in the range, or the like.

The following separately describes a solution in which a projection basis group is associated with a region and a solution in which a projection basis group is associated with an identity of a communication device.
1. The projection basis group is associated with the region.

The "region" in this application may be an actual geographical region, or may be logical region division. This is not limited. Details are not described below again.

In the solution in which the projection basis group is associated with the region, because the projection basis group is associated with the region, the first communication device may obtain, based on location information of the first communication device or the second communication device, a projection basis group corresponding to a region in which the first communication device or the second communication device is located, to compress the data to be sent to the second communication device. For example, when the first communication device is an access network device, and the second communication device is a terminal device, the access network device may obtain, based on a region in which the terminal device is located, a projection basis group corresponding to the region. For another example, when the first communication device is a terminal device, and the second communication device is an access network device, the terminal device may obtain, based on a region in which the terminal device is located, a projection basis group corresponding to the region.

For example, the solution in which the projection basis group is associated with the region of the communication device may be applied to a single-transmit single-receive scenario, for example, is applicable to projection compression of data sent by a transmit end device to a receive end device at different moments.

In the solution in which the projection basis group is associated with the region, the projection basis in the first projection basis group corresponds to a first region, the projection basis in the second projection basis group corresponds to a second region, and the second region is a sub-region of the first region.

The first data in the data to be sent to the second communication device corresponds to the second region. That data corresponds to a region may be understood as meaning that the data is obtained or collected from the region or a part of the region (for example, a sub-region of the region), the data is a summary of data in the region or the part of the region, the data is used to describe electromagnetic propagation characteristics of the region or the part of the region, or the like. In this way, that the first data corresponds to the second region may be understood as meaning that the first data is obtained or collected from the second region or a part of the second region, the first data is a summary of data in the second region or the part of the second region, or the first data is used to describe electromagnetic propagation characteristics of the second region or the part of the second region, or the like.

Because the projection basis group is associated with the region, that the first communication device obtains the first projection basis group and the second projection basis group may include: The first communication device obtains the location information of the first communication device or the second communication device, and obtains, based on the location information of the first communication device or the second communication device, the first projection basis group corresponding to the first region in which the first communication device or the second communication device is located, and the second projection basis group corresponding to the second region in which the first communication device or the second communication device is located.

Optionally, the first region is a cell, and the second region is a sub-region of the cell.

An implementation in which the first communication device obtains the location information of the first communication device or the second communication device is not limited in embodiments of this application.

In a possible implementation, for example, the first communication device is an access network device, and the second communication device is a terminal device. The first communication device obtains the location information of the second communication device, that is, the access network device obtains location information of the terminal device. In an example, when the terminal device has a positioning function, the access network device may receive the location information reported by the terminal device. In another example, when the access network device has a terminal device positioning function, the access network device may obtain the location information of the terminal device through measurement.

In another possible implementation, for example, the first communication device is a terminal device, and the second communication device is an access network device. The first communication device obtains the location information of the first communication device, that is, the terminal device obtains location information of the terminal device. In an example, when the terminal device has a positioning function, the terminal device may obtain the location information of the terminal device based on the positioning function. In another example, when the access network device has a terminal device positioning function, the terminal device may receive the location information of the terminal device indicated by the access network device.

In this embodiment of this application, the first projection basis group and the second projection basis group may be calculated by the first communication device. For example, the first communication device is an access network device, and the second communication device is a terminal device. The access network device may calculate the first projection basis group and the second projection basis group. The first projection basis group and the second projection basis group may alternatively be calculated by the second communication device. For example, the first communication device is a terminal device, and the second communication device is an access network device. The access network device may calculate the first projection basis group and the second projection basis group, and configure the first projection basis group and the second projection basis group for the terminal device. When the terminal device needs to send data to the access network device, the terminal device uses the first projection basis group and the second projection basis group that are configured by the access network device. In other words, the projection basis used for data compression may be determined by the data transmit end device, or may be determined by the data receive end device. Generally, the first projection basis group and the second projection basis group may be calculated by one end having a computing capability in the first communication device and the second communication device. The following separately describes two manners of determining the first projection basis group and the second projection basis group.
(1) The first projection basis group and the second projection basis group are determined by the first communication device.

Because the projection basis in the first projection basis group corresponds to the first region, the first communication device may calculate the first projection basis group based on data in a range of the first region. Specifically, the first communication device may determine the first projection basis group based on second data corresponding to the first region, where the second data is sample data used to determine the first projection basis group, and is data in the range of the first region. For example, the second data may be data currently to be sent in the first region, that is, when data needs to be sent, the first communication device calculates a corresponding projection basis group based on the current data. For example, the second data may alternatively be historical data in the first region, that is, the first projection basis group is calculated in advance. When data needs to be sent, the first communication device may read the first projection basis group that has been calculated previously.

An implementation in which the first communication device determines the first projection basis group based on the second data is limited in embodiments of this application. In a possible implementation, as shown in FIG. 4, the first communication device may perform SVD (for example, truncated SVD), LRMA, or the like on the second data, to obtain the first projection basis group.

Similarly, because the second projection basis group corresponds to the second region, the first communication device may calculate the second projection basis group based on data in a range of the second region. Specifically, the first communication device may determine the second projection basis group based on third data corresponding to the second region, where the third data is sample data used to determine the second projection basis group, and is data in the range of the second region. For example, the third data may be data currently to be sent in the second region, that is, when data needs to be sent, the first communication device calculates a corresponding projection basis group based on the current data. For example, the third data may alternatively be historical data in the second region, that is, the second projection basis group is calculated in advance. When data needs to be sent, the first communication device may read the second projection basis group that has been calculated previously.

An implementation in which the first communication device determines the second projection basis group based on the third data is not limited in embodiments of this application.

In a possible implementation, as shown in FIG. 4, the first communication device may perform SVD (for example, truncated SVD), LRMA, or the like on the third data, to obtain the second projection basis group. Corresponding to the implementation, in step 502, the first communication device may obtain only the second projection basis group. In another possible implementation, the first communication device may compress the third data based on the first projection basis group to obtain a second residual, and then determine the second projection basis group based on the second residual, for example, perform SVD (for example, truncated SVD), LRMA, or the like on the second residual to obtain the second projection basis group.

In this embodiment of this application, the first communication device may determine the first projection basis group and the second projection basis group in advance, and obtain, based on the location information of the first communication device or the second communication device when data needs to be sent, the first projection basis group corresponding to the first region in which the first communication device or the second communication device is located and the second projection basis group corresponding to the second region in which the first communication device or the second communication device is located. For example, it is assumed that the first communication device is an access network device, and the second communication device is a terminal device. When the terminal device is located in a sub-region A1 of a cell A, the access network device may obtain, based on the location information of the terminal device, a projection basis group corresponding to the cell A and a projection basis group corresponding to the sub-region A1.

When the first communication device determines the first projection basis group and the second projection basis group, the first communication device may further send the first projection basis group and/or the second projection basis group to the second communication device, so that the second communication device may decompress the received compressed data by using the same projection basis group.

A manner in which the first communication device sends the first projection basis group and/or the second projection basis group to the second communication device is not limited in embodiments of this application.

In a possible implementation, the first communication device may send, to the second communication device, a projection basis group corresponding to a location of the second communication device. For example, the first communication device may send a corresponding projection basis group to the second communication device when the second communication device enters a region. If the second communication device does not leave the region, the first communication device may always use the projection basis group provided to the second communication device, and the second communication device may also always use the received projection basis group. The projection basis group does not need to be updated between the two devices. Specifically, the first communication device may send the first projection basis group to the second communication device after the second communication device enters the first region, and send the second projection basis group to the second communication device after the second communication device enters the second region. For example, after the terminal device enters the sub-region A1 of the cell A from a cell B, the access network device may configure, for the terminal device, the projection basis group corresponding to the cell A and the projection basis group corresponding to the sub-region A1. For another example, after the terminal device enters a sub-region A2 of the cell A from the sub-region A1 of the cell A, the access network device may configure, for the terminal device, a projection basis group corresponding to the sub-region A2. Because the terminal device does not leave the cell A, the first communication device does not need to configure, for the terminal device, the projection basis group corresponding to the cell A.

In another possible implementation, the first communication device may send, to the second communication device, a projection basis group corresponding to a location of the second communication device and a projection basis group corresponding to an adjacent location of the location of the second communication device. This helps reduce signaling overheads caused by projection basis group sending. Specifically, the first communication device may send third information and/or fourth information to the second communication device. The third information indicates a first set, the first set includes a plurality of projection basis groups, the plurality of projection basis groups included in the first set respectively correspond to a plurality of sub-regions of the third region, and the plurality of sub-regions of the third region include the first region. The fourth information indicates a second set, the second set includes a plurality of projection basis groups, the plurality of projection basis groups included in the first set respectively correspond to a plurality of sub-regions of the first region, and the plurality of sub-regions of the first region include the second region. For a manner of determining a projection basis group corresponding to each of the plurality of sub-regions of the third region, refer to the manner of determining the first projection basis group. For a manner of determining a projection basis group corresponding to each of the plurality of sub-regions of the first region, refer to the manner of determining the second projection basis group. For example, after the terminal device enters the sub-region A1 of the cell A from the cell B, the access network device may configure, for the terminal device, the projection basis group corresponding to the cell A, the projection basis group corresponding to the sub-region A1, and projection basis groups respectively corresponding to adjacent sub-regions A2, A3, and A4 of the sub-region A1.

When the first communication device sends, to the second communication device, the projection basis group corresponding to the location of the second communication device and the projection basis group corresponding to the adjacent location of the location of the second communication device, to make the first communication device and the second communication device select a same projection basis group, in another manner, the first communication device may further send fifth information and/or sixth information to the second communication device, where the fifth information indicates the first projection basis group, and the sixth information indicates the second projection basis group. For example, when the first communication device sends the third information and the fourth information to the second communication device, the first communication device may further send the fifth information and the sixth information to the second communication device. For another example, when the first communication device sends the first projection basis group (not the first set) and the fourth information to the second communication device, the first communication device may further send the sixth information to the second communication device. The fifth information and/or the sixth information may be sent together with the compressed data, or may be sent separately from the compressed data. This is not limited.

An implementation of the fifth information and/or an implementation of the sixth information are/is not limited in embodiments of this application. In a possible implementation, the fifth information and/or the sixth information may be a bit string, a quantity of bits in a bit string corresponding to the fifth information is the same as a quantity of projection basis groups in the first set configured for the second communication device, a quantity of bits in a bit string corresponding to the sixth information is the same as a quantity of projection basis groups in the second set configured for the second communication device, and one bit in the bit string corresponds to one projection basis group. For example, the terminal device is located in the sub-region #A2 of the cell A, and the access network device configures, for the terminal device, the projection basis group corresponding to the cell A, a projection basis group #1 corresponding to the sub-region A1 of the cell A, a projection basis group #2 corresponding to the sub-region A2 of the cell A, a projection basis group #3 corresponding to the sub-region A3 of the cell A, and a projection basis group #4 corresponding to the sub-region A4 of the cell A. The access network device may indicate, to the terminal device by using the sixth information, the projection basis group #2 selected by the access network device, where the sixth information may be 0100. In another possible implementation, the fifth information and/or the sixth information may include a sequence number of a projection basis group. Specifically, the fifth information includes a sequence number of the first projection basis group, and the sixth information includes a sequence number of the second projection basis group. For example, the terminal device is located in the sub-region #A2 of the cell A, and the access network device configures, for the terminal device, the projection basis group corresponding to the cell A, a projection basis group #1 corresponding to the sub-region A1 of the cell A, a projection basis group #2 corresponding to the sub-region A2 of the cell A, a projection basis group #3 corresponding to the sub-region A3 of the cell A, and a projection basis group #4 corresponding to the sub-region A4 of the cell A, where sequence numbers of the projection basis group #1, the projection basis group #2, the projection basis group #3, and the projection basis group #4 are respectively 00, 01, 10, and 11. The access network device may indicate, to the terminal device by using the sixth information, the projection basis group #2 selected by the access network device, where the sixth information may include 01.

When the first communication device sends, to the second communication device, the projection basis group corresponding to the location of the second communication device and the projection basis group corresponding to the adjacent location of the location of the second communication device, to make the first communication device and the second communication device select a same projection basis group, in a manner, the first communication device may further send seventh information and/or eighth information to the second communication device, where the seventh information indicates a correspondence between the plurality of projection basis groups included in the first set and the plurality of sub-regions of the third region, and the eighth information indicates a correspondence between the plurality of projection basis groups included in the second set and the plurality of sub-regions of the first region. For example, when the first communication device sends the third information and the fourth information to the second communication device, the first communication device may further send the seventh information and the eighth information to the second communication device. For another example, when the first communication device sends the first projection basis group (not the first set) and the fourth information to the second communication device, the first communication device may further send the eighth information to the second communication device.

A manner of indicating a correspondence between a plurality of projection basis groups and a plurality of sub-regions is not limited in embodiments of this application. In a possible implementation, information about the plurality of sub-regions, a sequence number of each of the plurality of sub-regions, and a sequence number of a projection basis group corresponding to the sequence number of each sub-region may be indicated. The eighth information is used as an example. The eighth information may include information about the plurality of sub-regions of the first region, a number of each of the plurality of sub-regions of the first region, and a sequence number of a projection basis group corresponding to the sequence number of each sub-region. The information about the sub-region may be used to describe the sub-region. A specific manner of describing a sub-region is not limited in this application. For example, a sub-region may be described by using information such as a quadtree, an octree, or a spatial volume element.

(2) The first projection basis group and the second projection basis group are determined by the second communication device.

A manner in which the second communication device determines the first projection basis group and the second projection basis group is the same as the manner in which the first communication device determines the first projection basis group and the second projection basis group, and the second data and the third data based on which the second communication device calculates the first projection basis group and the second projection basis group may be previously transmitted by the first communication device to the second communication device.

When the first projection basis group and the second projection basis group are determined by the second communication device, the second communication device may further send the first projection basis group and/or the second projection basis group to the first communication device. A manner in which the second communication device sends the first projection basis group and/or the second projection basis group to the first communication device is the same as the manner in which the first communication device sends the first projection basis group and/or the second projection basis group to the second communication device. Details are not described again.

When the second communication device sends, to the first communication device, the projection basis group corresponding to the location of the second communication device and the projection basis group corresponding to the adjacent location of the location of the second communication device, to make the first communication device and the second communication device select a same projection basis group, the second communication device may further send tenth information and/or eleventh information to the first communication device. The tenth information indicates a correspondence between the plurality of projection basis groups included in the first set and the plurality of sub-regions of the third region, and the correspondence includes a correspondence between the first projection basis group and the first region. The eleventh information indicates a correspondence between the plurality of projection basis groups included in the second set and the plurality of sub-regions of the first region, and the correspondence includes a correspondence between the second projection basis group and the second region. In this case, when the first communication device receives the tenth information, that the first communication device obtains the first projection basis group includes: The first communication device retrieves the first projection basis group from the first set based on the location information of the first communication device or the second communication device. When the first communication device receives the eleventh information, that the first communication device obtains the second projection basis group includes: The first communication device retrieves the second projection basis group from the second set based on the location information of the first communication device or the second communication device.

2. The projection basis group is associated with the identity of the communication device.

In the solution in which the projection basis group is associated with the identity of the communication device, because the projection basis group is associated with the identity of the communication device, the first communication device may obtain, based on an identity of the first communication device or the second communication device, a projection basis group corresponding to a communication device group to which the identity of the first communication device or the second communication device belongs, to compress the data to be sent to the second communication device. For example, when the first communication device is an access network device and the second communication device is a terminal device, the access network device may obtain, based on a terminal device group to which the terminal device belongs, a projection basis group corresponding to the terminal device group.

For example, the solution in which the projection basis group is associated with the identity of the communication device may be applied to a scenario in which a transmit end device sends data to a plurality of receive end devices. Optionally, the transmit end device may be an access network device or a terminal device. Optionally, the receive end devices may include an access network device and/or a terminal device.

In the solution in which the projection basis group is associated with the identity of the communication device, the projection basis in the first projection basis group corresponds to a communication device group, that is, the projection basis in the first projection basis group is a projection basis shared by all communication devices in the communication device group; and the projection basis in the second projection basis group corresponds to a part of communication devices in the communication device group, that is, the projection basis in the second projection basis group is a projection basis used by the part of the communication devices in the communication device group. The second communication device is a communication device corresponding to the projection basis in the second projection basis group.

Because the projection basis group is associated with the region, that the first communication device obtains the first projection basis group and the second projection basis group may include: The first communication device obtains the first projection basis group corresponding to the communication device group based on the second communication device belonging to the communication device group, and obtains, based on the second communication device belonging to the part of the communication devices in the communication device group, the second projection basis group corresponding to the part of the communication devices. Optionally, the part of the communication devices in the communication device group may form another communication device group, that is, the projection basis in the second projection basis group corresponds to one communication device group, and the communication device group includes the part of the communication devices in the communication device group corresponding to the first projection basis group. It should be noted that, when there is only one communication device in a communication device group, a projection basis group corresponding to the communication device group is a projection basis group specific to the communication device. In this case, the projection basis group corresponding to the communication device group may alternatively be replaced with a projection basis group corresponding to the terminal device. For example, the communication device group is a multicast group to which the second communication device belongs, and the part of the communication devices in the communication device group includes only the second communication device (that is, the part of the communication devices in the communication device group is the second communication device). The first communication device obtains the multicast group to which the second communication device belongs, obtains the first projection basis group corresponding to the multicast group, and obtains the second projection basis group specific to the second communication device.

In the solution in which the projection basis group is associated with the identity of the communication device, the first projection basis group and the second projection basis group may be calculated by the first communication device. In this solution, for a manner in which the first communication device determines the first projection basis group and the second projection basis group, refer to the manner in which the first communication device determines the first projection basis group and the second projection basis group in the solution in which the projection basis group is associated with the region. A difference is that in the solution in which the projection basis group is associated with the identity of the communication device, the second data is data of the communication device group, and the third data is data of a part of terminal devices in the communication device group.

When the first communication device determines the first projection basis group and the second projection basis group, the first communication device may further send the first projection basis group and/or the second projection basis group to the second communication device, so that the second communication device may decompress the received compressed data by using the same projection basis group.

A manner in which the first communication device sends the first projection basis group and/or the second projection basis group to the second communication device is not limited in embodiments of this application. In a possible implementation, when the part of the communication devices in the communication device group is the second communication device, the first communication device may multicast the first projection basis group to the communication devices in the communication device group, and/or unicast the second projection basis group to the second communication device. In another possible implementation, when the part of the communication devices in the communication device group includes a plurality of communication devices, the first communication device may multicast the first projection basis group to the communication devices in the communication device group, and/or multicast the second projection basis group to the plurality of communication devices included in the part of the communication devices.

Step 503: The first communication device compresses the first data based on the first projection basis group to obtain a first projection result and a first residual.

Step 504: The first communication device compresses the first residual based on the second projection basis group to obtain a second projection result.

Step 505: The first communication device sends the compressed data to the second communication device. Correspondingly, the second communication device receives the compressed data from the first communication device.

The compressed data includes the first projection result and the second projection result.

Step 506: The second communication device obtains the first projection basis group and the second projection basis group.

When the first communication device determines the first projection basis group and the second projection basis group, that the second communication device obtains the first projection basis group and the second projection basis group may be that the second communication device receives the first projection basis group and/or the second projection basis group from the first communication device.

Optionally, when the projection basis group is associated with the region, the first projection basis group corresponds to the first region, and the second projection basis group corresponds to the second region. That the second communication device receives the first projection basis group and the second projection basis group from the first communication device may be that the second communication device receives the first projection basis group from the first communication device after entering the first region, and/or receives the second projection basis group from the first communication device after entering the second region.

Optionally, when the projection basis group is associated with the identity of the communication device, the first projection basis group corresponds to the communication device group, and the second projection basis group corresponds to the second communication device in the communication device group. That the second communication device receives the first projection basis group and the second projection basis group from the first communication device may be that the second communication device receives the first projection basis group that is multicast by the first communication device, and/or receives the second projection basis group that is unicast by the first communication device.

When the first communication device determines the first projection basis group and the second projection basis group, when the projection basis group is associated with the region, the second communication device may further receive the third information and the fifth information from the first communication device, where the third information indicates the first set, the first set includes the plurality of projection basis groups, the plurality of projection basis groups included in the first set respectively correspond to the plurality of sub-regions of the third region, the plurality of sub-regions of the third region include the first region, and the fifth information indicates the first projection basis group. In this case, that the second communication device obtains the first projection basis group may be that the second communication device obtains, from the first set based on the third information, the first projection basis group indicated by the third information. In addition/Alternatively, the second communication device may further receive the fourth information and the sixth information from the first communication device, where the fourth information indicates the second set, the second set includes the plurality of projection basis groups, the plurality of projection basis groups included in the second set respectively correspond to the plurality of sub-regions of the first region, the plurality of sub-regions of the first region include the second region, and the sixth information indicates the second projection basis group. In this case, that the second communication device obtains the second projection basis group may be that the second communication device obtains, from the second set based on the fourth information, the second projection basis group indicated by the fourth information.

When the first communication device determines the first projection basis group and the second projection basis group, when the projection basis group is associated with the region, the second communication device may further receive the third information and the seventh information from the first communication device, where the third information indicates the first set, the first set includes the plurality of projection basis groups, the plurality of projection basis groups included in the first set respectively correspond to the plurality of sub-regions of the third region, and the plurality of sub-regions of the third region include the first region, the seventh information indicates the correspondence between the plurality of projection basis groups included in the first set and the plurality of sub-regions of the third region. In this case, that the second communication device obtains the first projection basis group may be that the second communication device obtains the location information of the first communication device or the second communication device, and obtains, from the first set based on the obtained location information, third information, and seventh information, the first projection basis group corresponding to the first region in which the first communication device or the second communication device is located. In addition/Alternatively, the second communication device may further receive the fourth information and the eighth information from the first communication device, where the fourth information indicates the second set, the second set includes the plurality of projection basis groups, the plurality of projection basis groups included in the second set respectively correspond to the plurality of sub-regions of the first region, the plurality of sub-regions of the first region include the second region, and the eighth information indicates the correspondence between the plurality of projection basis groups included in the second set and the plurality of sub-regions of the first region. In this case, that the second communication device obtains the second projection basis group may be that the second communication device obtains the location information of the first communication device or the second communication device, and obtains, from the second set based on the obtained location information, fourth information, and eighth information, the second projection basis group corresponding to the second region in which the first communication device or the second communication device is located. It should be noted that although it is mentioned herein that the second communication device obtains the location information of the first communication device or the second communication device twice, the second communication device may actually obtain the location information only once. This implementation is applicable to a scenario in which both the first communication device and the second communication device can learn the location information, for example, a scenario in which the terminal device has a positioning function and can report the location information obtained through positioning to the access network device.

When the second communication device determines the first projection basis group and the second projection basis group, when the projection basis group is associated with the region, that the second communication device obtains the first projection basis group may be that the second communication device determines the first projection basis group based on the second data corresponding to the first region. In addition/Alternatively, that the second communication device obtains the second projection basis group may be that the second communication device determines the second projection basis group based on the third data corresponding to the second region. Optionally, in this case, the second communication device may further send the tenth information and/or the eleventh information to the first communication device. For a specific implementation, refer to the descriptions in step 502.

Step 507: The second communication device performs decompression based on the second projection basis group and the second projection result, to obtain the first residual.

Step 508: The second communication device performs decompression based on the first projection basis group and the first residual to obtain the first data.

In this way, based on the hierarchical structure of the air interface native data, the method 500 may use a hierarchical data compression solution, that is, a plurality of projection basis groups may be used to perform level-by-level projection compression on data, so that the hierarchical structure in data redundancy may be fully used to perform better projection compression on the to-be-sent data, thereby helping reduce transmission overheads. In addition, in the method 500, the projection basis group may be associated with the region or the identity of the communication device. When the communication device is not out of a region corresponding to a projection basis or does not leave a communication device group corresponding to the projection basis, the projection basis does not need to be updated, helping further reduce transmission overheads.

In some other embodiments of this application, when performing data compression, the first communication device may use a part of projection bases in the first projection basis group and/or a part of projection bases in the second projection basis group. In this case, the first communication device may further send first information and/or second information to the second communication device, where the first information indicates one or more projection bases in the first projection basis group that are used to compress the first data, and the second information indicates one or more projection bases in the second projection basis group that are used to compress the first residual, to indicate, to the second communication device, which projection bases in the first projection basis group and/or which projection bases in the second projection basis group are specifically used, so that the second communication device uses the corresponding projection bases to perform decompression.

In some other embodiments of this application, when the projection basis group is associated with the region, there is a case in which the second communication device is located at a boundary between the second region and a fourth region. The fourth region is also a sub-region of the first region. A part of the data to be sent to the second communication device may correspond to the second region, and the other part may correspond to the fourth region. For ease of description, the data corresponding to the second region is referred to as first data, and the data corresponding to the fourth region is referred to as fourth data. Both the first data and the fourth data belong to the data to be sent to the second communication device. In this case, a first processing manner is that the first communication device determines, based on a region that the second communication device is more inclined to, the region in which the second communication device is located. For example, if the second communication device is more inclined to the second region, the first communication device determines that the second communication device is located in the second region, and then uses the second projection basis group corresponding to the second region to perform projection compression on the data to be sent to the second communication device. For another example, if the second communication device is more inclined to the fourth region, the first communication device determines that the second communication device is located in the fourth region, and then uses the fourth projection basis group corresponding to the fourth region to perform projection compression on the data to be sent to the second communication device. A second processing manner is that the first communication device separately performs projection compression on corresponding data based on the second projection basis group corresponding to the second region and the fourth projection basis group corresponding to the fourth region. In the second processing manner, step 504 may be specifically that the first communication device compresses the first data and the fourth data based on the first projection basis group to obtain the first projection result and the first residual. In this case, the first residual includes a first sub-part and a second sub-part, the first sub-part corresponds to the first data, and the second sub-part corresponds to the fourth data. Step 505 may be specifically that the first communication device compresses the first sub-part of the first residual based on the second projection basis group to obtain the second projection result. The first communication device may further obtain a fourth projection basis group corresponding to the fourth region, and compress the second sub-part of the first residual based on the fourth projection basis group to obtain a fourth projection result.

In the second processing manner, the compressed data in step 505 may further include the fourth projection result corresponding to the fourth data. For the second communication device side, step 507 may be specifically that the second communication device may perform decompression based on the second projection basis group and the second projection result to obtain the first sub-part of the first residual; and the second communication device may further obtain the fourth projection basis group, and perform decompression based on the fourth projection basis group and the fourth projection result to obtain the second sub-part of the first residual. Step 508 may be specifically that the second communication device performs decompression based on the first projection basis group, the first sub-part of the first residual, and the second sub-part of the first residual to obtain the first data.

In addition, in the second processing manner, the first communication device may further send ninth information to the second communication device, so that the second communication device can recover an original data sequence. Correspondingly, the second communication device receives the ninth information from the first communication device, where the ninth information indicates a location of the first data and/or a location of the fourth data in the data to be sent to the second communication device.

In some other embodiments of this application, the compressed data in step 505 further includes the second residual. The second residual may be a residual obtained when the first residual is compressed based on the second projection basis group, that is, the first communication device may obtain the second projection result and the second residual by compressing the first residual based on the second projection basis group. Alternatively, the second residual may be a subsequent processing result of the residual obtained when the first residual is compressed based on the second projection basis group. For example, the first communication device compresses the first residual based on the second projection basis group to obtain the second projection result and a residual corresponding to the second projection result. Subsequently, the first communication device may perform further processing (for example, further compression processing) on the residual corresponding to the second projection result to obtain the second residual. In this case, step 507 may be that the second communication device performs decompression based on the second projection basis group, the second projection result, and the second residual to obtain the first residual.

In some other embodiments of this application, projection compression of more than two levels may alternatively be performed on the data to be sent to the second communication device. In this case, for the first communication device side, the first communication device may further obtain a third projection basis group, where a projection basis in the third projection basis group corresponds to a third range, and the third range is a sub-range of the second range. Step 504 may be specifically that the first communication device compresses the first residual based on the second projection basis group to obtain the second projection result and a third residual, and the first communication device may further compress the third residual based on the third projection basis group to obtain a third projection result. The compressed data in step 505 may further include the third projection result. For the second communication device side, the second communication device may further obtain the third projection basis group, and performs decompression based on the third projection basis group and the third projection result to obtain the third residual. Step 507 may be specifically performing decompression based on the second projection basis group, the second projection result, and the third residual to obtain the first residual.

The following describes embodiments of this application in detail by using an example in which a hierarchical structure of a projection basis is two layers, the first communication device is a base station, the second communication device is a UE, and the to-be-sent data is RF map data.

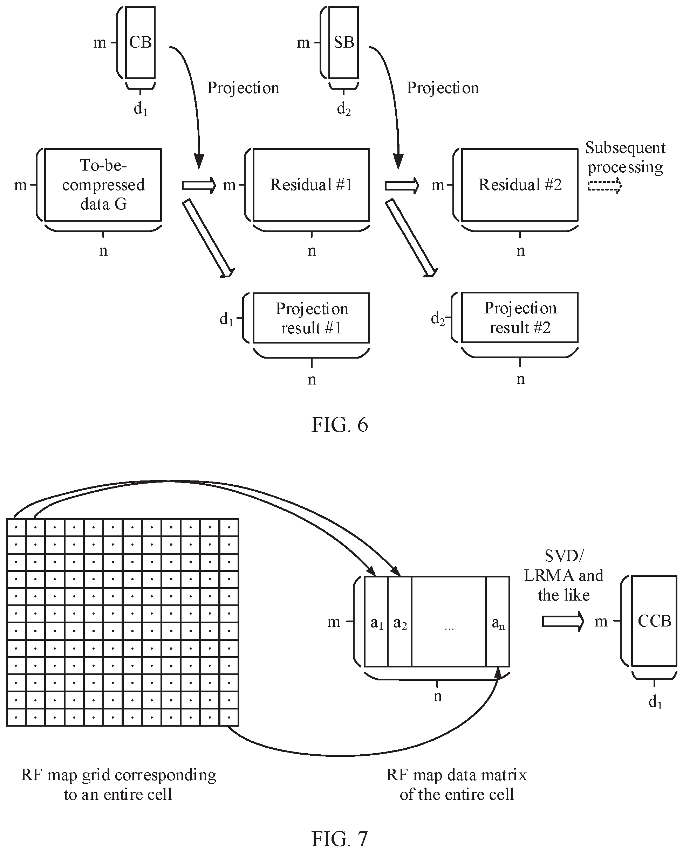

FIG. 6 is a diagram of an overall procedure of data compression based on two layers of projection bases.

As shown in FIG. 6, the base station obtains a group of projection bases, where the group of projection bases has a two-layer hierarchical structure, a first layer is a common projection basis (common basis, CB), and a second layer is a specific projection basis (specific basis, SB). The base station performs layer-by-layer compression on the to-be-compressed data by using the CB and the SB. Specifically, as shown in FIG. 6, the base station first uses the CB to perform projection compression on the to-be-compressed data to obtain a projection result #1 and a residual #1, and then uses the SB to further perform projection compression on the residual #1 to obtain a projection result #2 and a residual #2. Then, the base station sends the projection result #1 and the projection result #2 to the UE. Optionally, the base station may further send the residual #2 to the UE, or if further processing (for example, compression processing) is further performed on the residual #2 subsequently, the base station may further send a result of subsequent processing performed on the residual #2 to the UE.

The CB may correspond to the first projection basis in the method 500, and the SB may correspond to the second projection basis in the method 500.

A manner of setting the two layers of projection bases is not limited in embodiments of this application. For example, there may be two manners described below: Manner 1 and Manner 2.

Manner 1: The projection basis is associated with a geographical region.

In Manner 1, the first layer in the two-layer structure of the projection bases is associated with a cell, and the second layer is associated with a sub-region of the cell. For ease of description, the first-layer projection basis in Manner 1 is referred to as a cell common projection basis (cell common basis, CCB), and the second-layer projection basis is referred to as a region-specific projection basis (region specific basis, RSB). It should be noted that the CCB is a group of projection bases, or the CCB includes one or more projection bases. The RSB is a group of projection bases, or the RSB includes one or more projection bases. The cell may correspond to the first region in the method 500, and the sub-region of the cell may correspond to the second region in the method 500.

### (1) CCB

The CCB is associated with a cell, and is a projection basis applicable to a geographical range corresponding to the cell. In other words, the CCB is a common projection basis of UEs in the cell. Based on a current location of the UE, if the UE is in a cell, the base station and the UE may use a CCB corresponding to the cell, and the base station and the UE may always use the CCB of the cell as long as the UE does not leave the cell.

A quantity d₁ of projection bases (or base vectors) included in the CCB needs to be configured in advance, for example, configured by using RRC signaling. The CCB may be obtained based on data of an entire geographical range of the cell associated with the CCB.

FIG. 7 is a diagram of determining the CCB. As shown in FIG. 7, an RF map grid of the entire geographical range of the cell associated with the CCB may be mapped to an RF map data matrix whose size is m×n. For detailed descriptions, refer to FIG. 3. SVD (for example, truncated SVD), LRMA, or the like is performed on the RF map data matrix whose size is m×n, and the RF map data matrix whose size is m×n may be approximately represented by a product of a matrix whose size is m×d₁ and a matrix whose size is d₁×n (not shown in FIG. 7). The matrix whose size is m×d₁ is the CCB.

### (2) RSB

The RSB is associated with the sub-region of the cell, and is a projection basis applicable to the sub-region of the cell. In other words, the RSB is a projection basis used by a UE in the sub-region of the cell. Different RSBs correspond to different sub-regions in the cell. Specifically, the cell may be divided into a plurality of sub-regions, and each sub-region corresponds to one group of projection bases (namely, RSBs). Based on a current location of the UE, if the UE is located in a sub-region of the cell, the base station may perform projection compression by using an RSB corresponding to the sub-region, and the UE may perform data restoration by using the RSB corresponding to the sub-region. When the UE is handed over to another sub-region in the cell, the base station may perform projection compression by using an RSB corresponding to the sub-region to which the UE is handed over, and the UE may perform data restoration by using the RSB corresponding to the sub-region to which the UE is handed over.

A manner of dividing a cell into a plurality of sub-regions is not limited in embodiments of this application. In an example, a cell may be divided into a plurality of sub-regions based on a geographical location. In another example, data in a cell range may be clustered based on a preset algorithm, to obtain a plurality of types of data, and one type of data may correspond to one sub-region.

A quantity d_{2,i} of projection bases (or base vectors) included in an RSB #i of an i^{th} sub-region of the cell needs to be configured in advance, for example, configured by using RRC signaling, where i is a positive integer. The RSB #i may be obtained based on data in the i^{th} sub-region range of the cell.

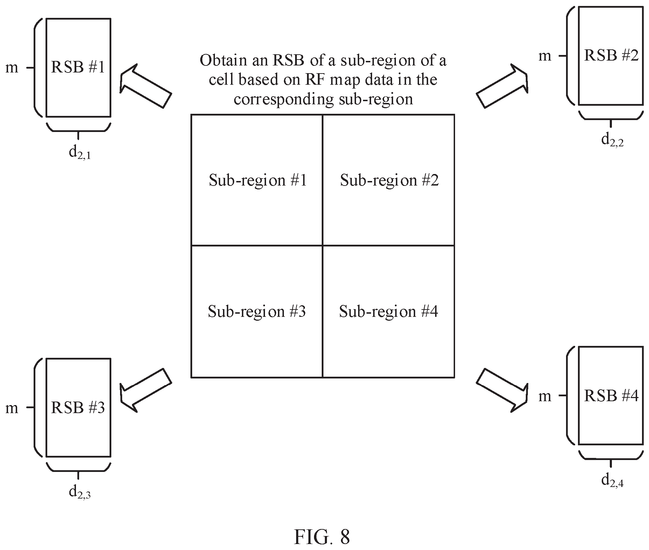

FIG. 8 is a diagram of a correspondence between an RSB and a sub-region. In FIG. 8, an example in which the cell is divided into a sub-region #1, a sub-region #2, a sub-region #3, and a sub-region #4 is used. As shown in FIG. 8, an RSB #1 whose size is m×d_{2,1} is obtained by using data in a range of the sub-region #1, and the RSB #1 is applicable to the sub-region #1; an RSB #2 whose size is m×d_{2,2} is obtained by using data in a range of the sub-region #2, and the RSB #2 is applicable to the sub-region #2; an RSB #3 whose size is m×d_{2,3} is obtained by using data in a range of the sub-region #3, and the RSB #1 is applicable to the sub-region #3; and an RSB #4 whose size is m×d_{2,4} is obtained by using data in a range of the sub-region #4, and the RSB #4 is applicable to the sub-region #4.

An implementation of determining the RSB is not limited in embodiments of this application.

In a possible implementation, an RF map grid corresponding to each sub-region may be mapped to an RF map data matrix corresponding to the sub-region, then the CCB is used to perform projection compression on the RF map data matrix corresponding to the sub-region, to obtain a projection coefficient and a residual, and then SVD (for example, truncated SVD), LRMA, or the like is performed on the obtained residual, to obtain the RSB of the sub-region. The CCB may be obtained based on data of an entire geographical range of the cell associated with the CCB.

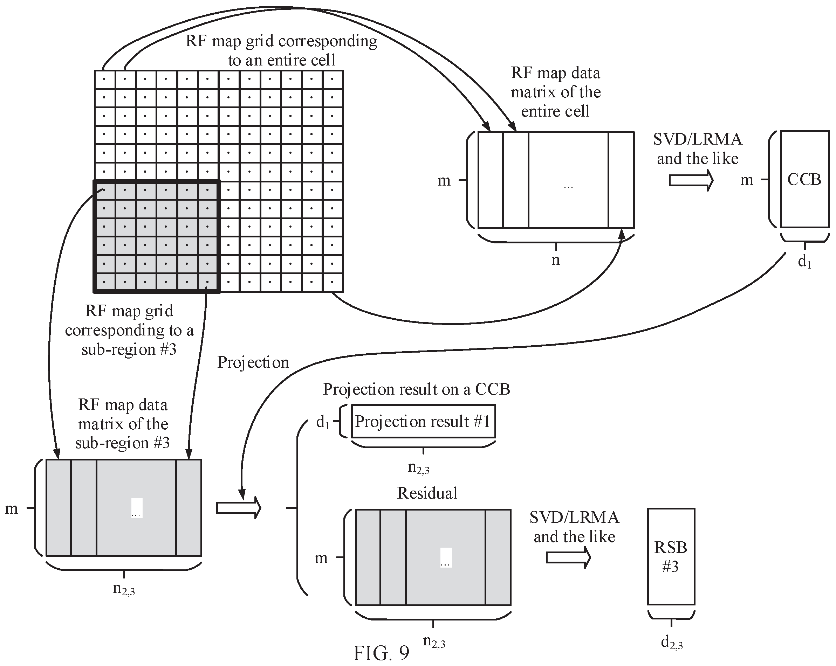

FIG. 9 is an example of an implementation of determining the RSB. In FIG. 9, an example in which the RSB #3 of the sub-region #3 of the cell is determined is used.

First, the CCB is obtained. For an implementation, refer to FIG. 7.

Then, an RF map grid corresponding to the sub-region #3 is mapped to an RF map data matrix whose size is m×n_{2,3}, and the CCB is used to perform projection compression on the RF map data matrix whose size is m×n_{2,3} to obtain a projection result whose size is d₁×n_{2,3} and a residual whose size is m×n_{2,3}. Further, SVD (for example, truncated SVD), LRMA, or the like is performed on the residual whose size is m×n_{2,3}. The residual whose size is m×n_{2,3} may be approximately represented by a product of a matrix whose size is m×d_{2,3} and a matrix whose size is d_{2,3}×n_{2,3} (not shown in FIG. 9). The matrix whose size is m×d_{2,3} is the RSB #3.

In another possible implementation, an RF map grid corresponding to each sub-region may be mapped to an RF map data matrix corresponding to the sub-region, and then SVD (for example, truncated SVD), LRMA, or the like is performed on the RF map data matrix corresponding to the sub-region, to obtain an RSB of the sub-region. In this manner, the RSB is determined without depending on the CCB.

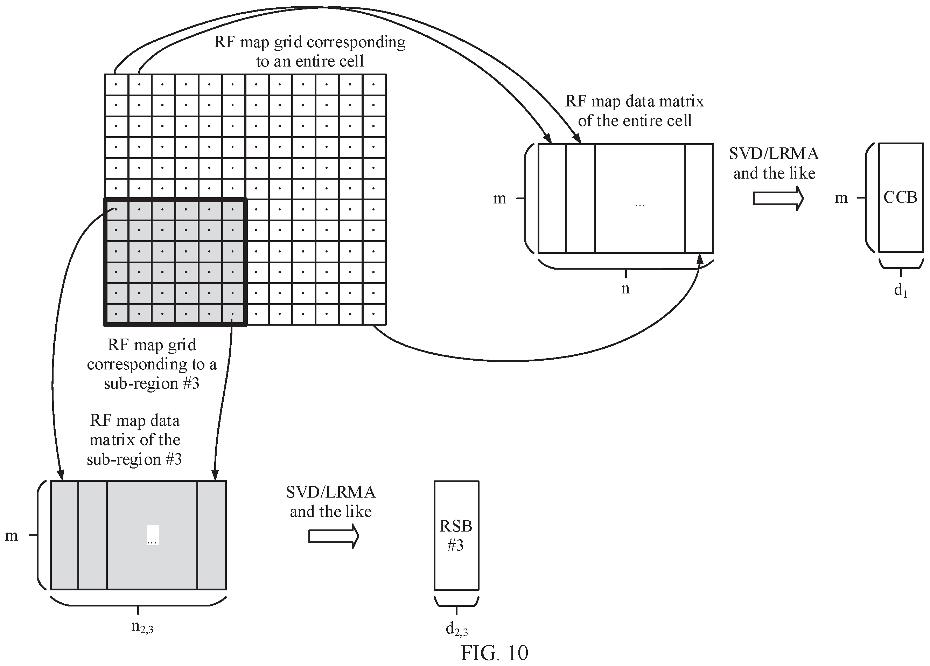

FIG. 10 is another example of an implementation of determining the RSB. In FIG. 10, the example in which the RSB #3 of the sub-region #3 of the cell is determined is also used.

As shown in FIG. 10, an RF map grid corresponding to the sub-region #3 is mapped to an RF map data matrix whose size is m×n_{2,3}. SVD (for example, truncated SVD), LRMA, or the like is performed on the RF map data matrix whose size is m×n_{2,3}, and the RF map data matrix whose size is m×n_{2,3} may be approximately represented by a product of a matrix whose size is m×d_{2,3} and a matrix whose size is d_{2,3}×n_{2,3} (not shown in FIG. 10). The matrix whose size is m×d_{2,3} is the RSB #3.

In Manner 1, the base station may configure, for the UE in advance, the CCB of the cell in which the UE is located and the RSB of the sub-region in which the UE is located. In subsequent data transmission, the base station performs layer-by-layer projection compression on data G by using the CCB and the RSB that are configured for the UE, to obtain a projection result #1, a projection result #2, and a residual #2 (for the projection result #1, the projection result #2, and the residual #2, refer to FIG. 6), and sends the projection result #1, the projection result #2, and the optional residual #2 to the UE. Correspondingly, the UE performs layer-by-layer recovery of the data by using the CCB and the RSB that are configured for the UE. Specifically, the UE recovers a residual #1' based on the RSB and the projection result #2, and recovers data G' based on the CCB and the projection result #1.

A manner in which the base station configures the CCB for the UE is not limited in embodiments of this application.

In a possible implementation, the base station may broadcast the CCB in the cell, and correspondingly, the UE receives the CCB broadcast by the base station.

A manner in which the base station configures the RSB for the UE is not limited in embodiments of this application.

In a first possible implementation, the base station may configure an RSB of a sub-region in the cell for the UE when the UE enters or is handed over to the sub-region.

With reference to specific examples, the following describes configuration of the CCB and the RSB and data transmission in the first possible implementation.

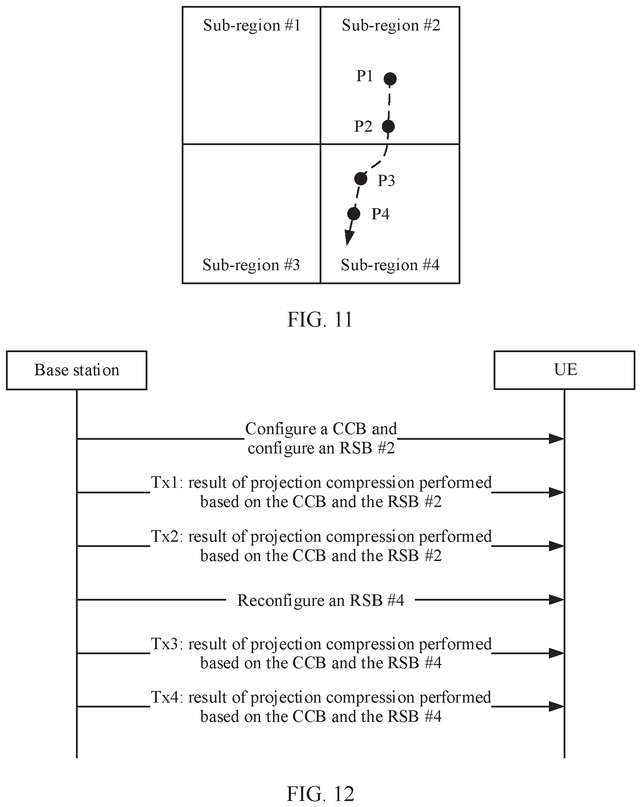

FIG. 11 is a diagram of a moving path of the UE. In FIG. 11, an example in which the cell is divided into a sub-region #1, a sub-region #2, a sub-region #3, and a sub-region #4 is used. A dashed line with an arrow in FIG. 11 represents the moving path of the UE, and includes locations P1, P2, P3, and P4.

FIG. 12 is an example of the configuration of the CCB and the RSB and the data transmission. FIG. 12 is based on the moving path of the UE shown in FIG. 11. Four times of data transmission Tx#1, Tx#2, Tx#3, and Tx#4 in FIG. 12 respectively correspond to the locations P1, P2, P3, and P4 in the moving path of the UE.

As shown in FIG. 11, the UE is initially located in the sub-region #2, and the base station configures the CCB and an RSB #2 of the sub-region #2 for the UE.

When the UE moves to P1, the base station performs data transmission Tx#1. In this case, the UE is located in the sub-region #2. The base station performs projection compression on data #1 based on the CCB and the RSB #2, and sends a projection compression result to the UE. Correspondingly, the UE performs data restoration based on the CCB, the RSB #2, and the received projection compression result. The projection compression result includes: a projection result of the data #1 on the CCB, a projection result of a residual of CCB-based projection compression on the RSB #2, and optionally, a residual of the residual of the CCB-based projection compression on the RSB #2.

When the UE moves to P2, the base station performs data transmission Tx#2. In this case, the UE is still located in the sub-region #2. The base station performs projection compression on data #2 based on the CCB and the RSB #2, and sends a projection compression result to the UE. Correspondingly, the UE performs data restoration based on the CCB, the RSB #2, and the received projection compression result. The projection compression result includes: a projection result of the data #2 on the CCB, a projection result of a residual of CCB-based projection compression on the RSB #2, and optionally, a residual of the residual of the CCB-based projection compression on the RSB #2.

As the UE moves, the UE leaves the sub-region #2 and enters the sub-region #4. In this case, the base station may reconfigure an RSB #4 of the sub-region #4 for the UE.

When the UE moves to P3, the base station performs data transmission Tx#3. In this case, the UE is located in the sub-region #4. The base station performs projection compression on data #3 based on the CCB and the RSB #4, and sends a projection compression result to the UE. Correspondingly, the UE performs data restoration based on the CCB, the RSB #4, and the received projection compression result. The projection compression result includes: a projection result of the data #3 on the CCB, a projection result of a residual of CCB-based projection compression on the RSB #4, and optionally, a residual of the residual of the CCB-based projection compression on the RSB #4.

When the UE moves to P4, the base station performs data transmission Tx#4. In this case, the UE is still located in the sub-region #4. The base station performs projection compression on data #4 based on the CCB and the RSB #4, and sends a projection compression result to the UE. Correspondingly, the UE performs data restoration based on the CCB, the RSB #4, and the received projection compression result. The projection compression result includes: a projection result of the data #4 on the CCB, a projection result of a residual of CCB-based projection compression on the RSB #4, and optionally, a residual of the residual of the CCB-based projection compression on the RSB #4.

In a second possible implementation, the base station may configure an RSB of a sub-region in the cell and an RSB of a neighboring sub-region of the sub-region for the UE when the UE enters or is handed over to the sub-region. In this implementation, the base station may configure, for the UE, the RSB of the sub-region in which the UE is located and the RSB of the neighboring sub-region of the sub-region in which the UE is located. When the UE moves in a range of these sub-regions, the base station and the UE only need to select an RSB of the sub-region in which the UE is currently located, and the base station does not need to update and configure an RSB for the UE. This helps reduce repeated RSB configuration caused by frequent handover of the UE between the sub-regions, thereby helping reduce a waste of resources caused by repeated RSB configuration.

For example, the base station may configure RSBs of all sub-regions in the cell for the UE at a time. In this way, when the UE moves in the cell, the base station does not need to update and configure the CCB and the RSB for the UE.

In the second possible implementation, the base station may select, based on location information of the UE, an RSB used for data compression from the plurality of RSBs. The location information of the UE may be reported to the base station by the UE having a positioning capability and a location information reporting capability, or may be determined by the base station having a UE positioning function.

In the second possible implementation, the UE may select, based on the location information of the UE or RSB indication information from the base station, an RSB used for data restoration from the plurality of RSBs configured by the base station for the UE. The RSB indication information indicates the RSB selected by the base station, the RSB used for data compression, or the RSB used for data restoration in the plurality of RSBs that have been configured for the UE. When the UE selects, based on the location information of the UE, the RSB used for data restoration from the plurality of RSBs configured by the base station for the UE, the base station further needs to indicate a correspondence between a sub-region and an RSB to the UE. The location information of the UE may be obtained by the UE having the positioning capability, or may be indicated by the base station to the UE. The RSB indication information may correspond to the sixth information in the method 500.

There are many implementations of the RSB indication information. This is not limited.

In an example, a bit string may indicate the RSB selected by the base station, the RSB used for data compression, or the RSB used for data restoration. A quantity of bits in the bit string is the same as a quantity of RSBs configured for the UE, and one bit in the bit string corresponds to one RSB. For example, the base station configures an RSB #1 of a sub-region #1, an RSB #2 of a sub-region #2, an RSB #3 of a sub-region #3, and an RSB #4 of a sub-region #4 for the UE. The base station may send the RSB indication information to the UE to indicate the RSB selected by the base station, the RSB used for data compression, or the RSB used for data restoration. The RSB indication information may be 1000, 0100, 0010, or 0001, where 1000 represents the RSB #1 of the sub-region #1, 0100 represents the RSB #2 of the sub-region #2, 0010 represents the RSB #3 of the sub-region #3, and 0001 represents the RSB #4 of the sub-region #4.

In another example, the RSB selected by the base station, the RSB used for data compression, or the RSB used for data restoration may be indicated by a sequence number of the RSB (namely, a subscript of the RSB). For example, the base station configures an RSB #1 of a sub-region #1, an RSB #2 of a sub-region #2, an RSB #3 of a sub-region #3, and an RSB #4 of a sub-region #4 for the UE, and sequence numbers of the RSB #1, the RSB #2, the RSB #3, and the RSB #4 are respectively 00, 01, 10, and 11. The RSB indication information may be 00, 01, 10, or 11.

With reference to specific examples, the following describes configuration of the CCB and the RSB and data transmission in the second possible implementation.

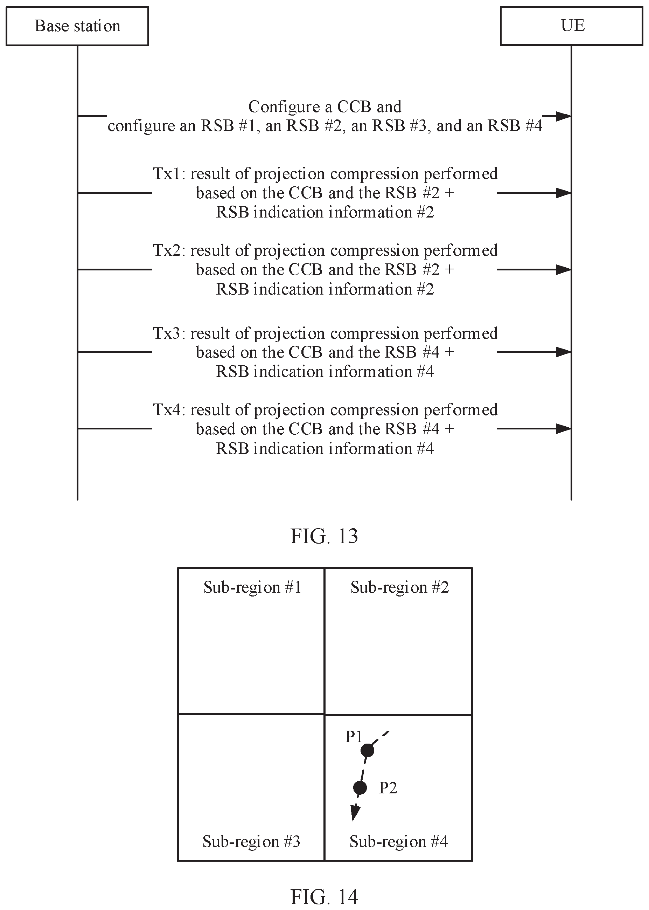

FIG. 13 is another example of the configuration of the CCB and the RSB and the data transmission. FIG. 13 uses an example in which the base station sends RSB indication information to UE. FIG. 13 is also based on the moving path of the UE shown in FIG. 11. Four times of data transmission Tx#1, Tx#2, Tx#3, and Tx#4 in FIG. 13 respectively correspond to the locations P1, P2, P3, and P4 in the moving path of the UE.

As shown in FIG. 11, the UE is initially located in the sub-region #2, and the base station configures the CCB, the RSB #2 of the sub-region #2, the RSB #1 of the neighboring sub-region #1 of the sub-region #2, the RSB #3 of the neighboring sub-region #3 of the sub-region #2, and the RSB #4 of the neighboring sub-region #4 of the sub-region #2 for the UE.

When the UE moves to P1, the base station performs data transmission Tx#1. In this case, the UE is located in the sub-region #2, and the base station performs projection compression on the data #1 based on the CCB and the RSB #2, and sends a projection compression result and RSB indication information #2 to the UE, where the RSB indication information #2 indicates the RSB #2. Correspondingly, the UE selects the RSB #2 based on the RSB indication information #2, and further performs data restoration based on the CCB, the RSB #2, and the received projection compression result. The projection compression result includes: a projection result of the data #1 on the CCB, a projection result of a residual of CCB-based projection compression on the RSB #2, and optionally, a residual of the residual of the CCB-based projection compression on the RSB #2.

When the UE moves to P2, the base station performs data transmission Tx#2. In this case, the UE is still located in the sub-region #2, and the base station performs projection compression on the data #2 based on the CCB and the RSB #2, and sends a projection compression result and RSB indication information #2 to the UE, where the RSB indication information #2 indicates the RSB #2. Correspondingly, the UE selects the RSB #2 based on the RSB indication information #2, and further performs data restoration based on the CCB, the RSB #2, and the received projection compression result. The projection compression result includes: a projection result of the data #2 on the CCB, a projection result of a residual of CCB-based projection compression on the RSB #2, and optionally, a residual of the residual of the CCB-based projection compression on the RSB #2.

As the UE moves, the UE leaves the sub-region #2 and enters the sub-region #4.

When the UE moves to P3, the base station performs data transmission Tx#3. In this case, the UE is located in the sub-region #4, and the base station performs projection compression on the data #3 based on the CCB and the RSB #4, and sends a projection compression result and RSB indication information #4 to the UE, where the RSB indication information #4 indicates the RSB #4. Correspondingly, the UE selects the RSB #2 based on the RSB indication information #4, and further performs data restoration based on the CCB, the RSB #4, and the received projection compression result. The projection compression result includes: a projection result of the data #3 on the CCB, a projection result of a residual of CCB-based projection compression on the RSB #4, and optionally, a residual of the residual of the CCB-based projection compression on the RSB #4.

When the UE moves to P4, the base station performs data transmission Tx#4. In this case, the UE is still located in the sub-region #4, and the base station performs projection compression on the data #4 based on the CCB and the RSB #4, and sends a projection compression result and RSB indication information #4 to the UE, where the RSB indication information #4 indicates the RSB #4. Correspondingly, the UE selects the RSB #2 based on the RSB indication information #4, and further performs data restoration based on the CCB, the RSB #4, and the received projection compression result. The projection compression result includes: a projection result of the data #3 on the CCB, a projection result of a residual of CCB-based projection compression on the RSB #4, and optionally, a residual of the residual of the CCB-based projection compression on the RSB #4.

The foregoing describes a solution in which the base station and the UE use all projection bases in the CCB or the RSB. In this embodiment of this application, there is no limitation that the base station and the UE have to use all projection bases corresponding to the current cell and/or all projection bases corresponding to the current sub-region, that is, there is no limitation that the base station and the UE have to use all projection bases of the CCB and/or all projection bases of the RSB. The base station and the UE may use a subset of the CCB and/or a subset of the RSB for projection compression and data restoration.

When the subset of the CCB and/or the subset of the RSB is used, the base station further sends CCB-part usage indication information and/or RSB-part usage indication information to the UE. The CCB-part usage indication information is used for a projection basis group #1, the projection basis group #1 is a subset of the CCB, a projection basis in the projection basis group #1 is a projection basis in the CCB used for data compression. The RSB-part usage indication information is used for a projection basis group #2, and the projection basis group #2 is a subset of the RSB, a projection basis in the projection basis group #2 is a projection basis in the RSB used for data compression. The CCB-part usage indication information may correspond to the first information in the method 500, and the RSB-part usage indication information may correspond to the second information in the method 500.

There are many implementations of the CCB-part usage indication information and/or the RSB-part usage indication information. This is not limited.

In an example, the CCB-part usage indication information and/or the RSB-part usage indication information may be a bit string. A quantity of bits in the bit string corresponding to the CCB-part usage indication information is the same as a quantity of projection bases in the projection basis group #1, and one bit in the bit string corresponds to one projection basis in the projection basis group #1. A quantity of bits in the bit string corresponding to the RSB-part usage indication information is the same as a quantity of projection bases in the projection basis group #2, and one bit in the bit string corresponds to one projection basis in the projection basis group #2. For example, the base station configures the CCB and the RSB #4 of the sub-region #4 for the UE. The CCB includes projection bases A, B, C, and D, and the RSB includes projection bases E, F, G, H, I, J, K, and L. When performing projection compression on data, the base station uses the projection bases A, B, and C in the CCB and the projection bases G, H, I, J, K, and L in the RSB. The CCB-part usage indication information may be a bit string 1110, and the RSB-part usage indication information may be a bit string 00111111.

In another example, the CCB-part usage indication information and/or the RSB-part usage indication information may be a number set of the projection bases (namely, a subscript set of the projection bases). For example, the base station configures the CCB and the RSB #4 of the sub-region #4 for the UE. The CCB includes projection bases A, B, C, and D, and sequence numbers of the projection bases A, B, C, and D are respectively 00, 01, 10, and 11. The RSB includes projection bases E, F, G, H, I, J, K, and L, and sequence numbers of the projection bases E, F, G, H, I, J, K, and L are respectively 000, 001, 010, 011, 100, 101, 110, and 111. When performing projection compression on data, the base station uses projection bases A, B, and C in the CCB and projection bases G, H, I, J, K, and L in the RSB. A number set corresponding to the CCB-part usage indication information is {00, 01, 10}, and a number set corresponding to the RSB-part usage indication information is {010, 011, 100, 101, 110, 111}.

With reference to specific examples, the following describes configuration of the CCB and the RSB and data transmission when the subset of the CCB and/or the subset of the RSB is used.

FIG. 14 is another diagram of a moving path of the UE. In FIG. 14, an example in which the cell is divided into a sub-region #1, a sub-region #2, a sub-region #3, and a sub-region #4 is used. A dashed line with an arrow in FIG. 14 represents the moving path of the UE, and includes locations P1 and P2.

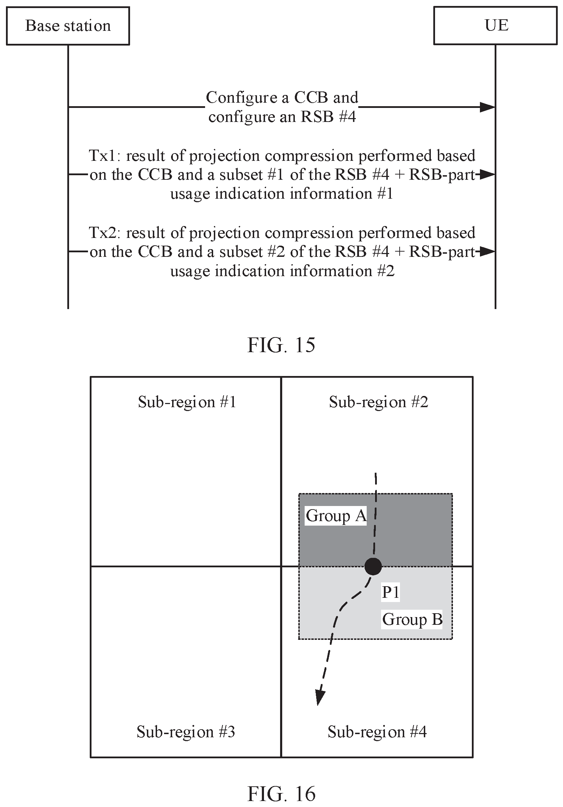

FIG. 15 is another example of the configuration of the CCB and the RSB and the data transmission. FIG. 15 is based on the moving path of the UE shown in FIG. 14. Two times of data transmission Tx#1 and Tx#2 in FIG. 15 respectively correspond to the locations P1 and P2 in the moving path of the UE.

As shown in FIG. 14, the UE is initially located in the sub-region #4, and the base station configures the CCB and an RSB #4 of the sub-region #4 for the UE.

When the UE moves to P1, the base station performs data transmission Tx#1. In this case, the UE is located in the sub-region #4, and the base station performs projection compression on the data #1 based on a subset #1 of the RSB #4 and the CCB, and sends a projection compression result and RSB-part usage indication information #1 to the UE, where the RSB-part usage indication information #1 indicates the subset #1 of the RSB #4. Correspondingly, the UE determines the subset #1 of the RSB #4 based on the RSB-part usage indication information #1, and performs data restoration based on the CCB, the subset #1 of the RSB #4, and the received projection compression result. The projection compression result includes: a projection result of the data #1 on the CCB, a projection result of a residual of CCB-based projection compression on the subset #1 of the RSB #4, and optionally, a residual of the residual of the CCB-based projection compression on the subset #1 of the RSB #4.

When the UE moves to P2, the base station performs data transmission Tx#2. In this case, the UE is still located in the sub-region #4, and the base station performs projection compression on the data #2 based on a subset #2 of the RSB #4 and the CCB, and sends a projection compression result and RSB-part usage indication information #2 to the UE, where the RSB-part usage indication information #2 indicates the subset #2 of the RSB #4. Correspondingly, the UE determines the subset #2 of the RSB #4 based on the RSB-part usage indication information #2, and performs data restoration based on the CCB, the subset #2 of the RSB #4, and the received projection compression result. The projection compression result includes: a projection result of the data #2 on the CCB, a projection result of a residual of CCB-based projection compression on the subset #2 of the RSB #4, and optionally, a residual of the residual of the CCB-based projection compression on the subset #2 of the RSB #4.

The following uses the second processing manner in the method 500 as an example to describe in detail a solution in a case in which the UE is located at a boundary of two sub-regions with reference to FIG. 16 to FIG. 18.

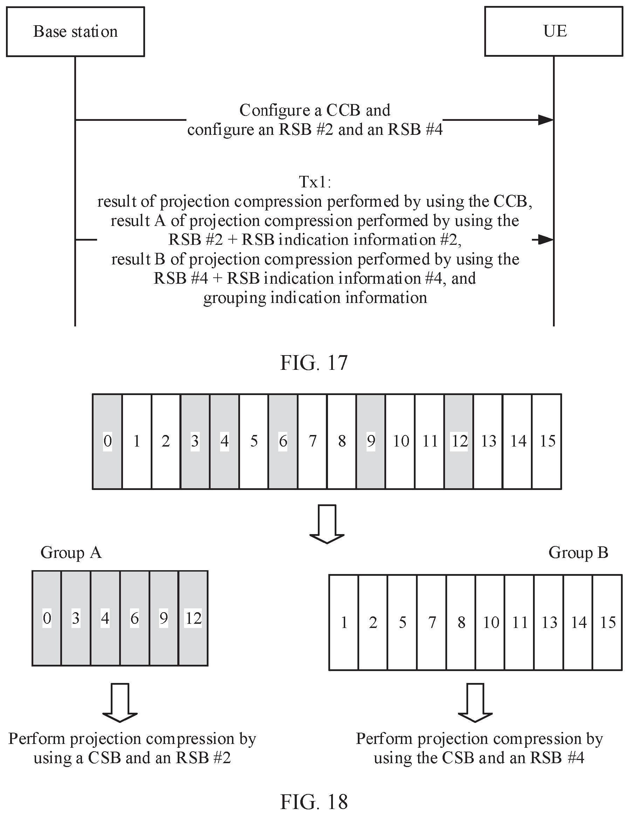

In FIG. 16 and FIG. 18, overlapping grouping compression is introduced. Specifically, to-be-sent data is grouped based on different sub-regions, and projection compression is performed on each group of data by using an RSB of a corresponding sub-region.

FIG. 16 is another diagram of a moving path of the UE. A dashed line with an arrow in FIG. 16 represents a moving path of the UE, including a location P1, where P1 is located at a position of a boundary between the sub-region #2 and the sub-region #4, and data to be sent to the UE corresponds to a range in which a shadow is located. It can be learned that, based on an overlapping status of the sub-region #2 and the sub-region #4, the data to be sent to the UE is divided into two groups: a group A (GroupA) and a group B (GroupB).

FIG. 17 is another example of the configuration of the CCB and the RSB and the data transmission. FIG. 17 is based on the moving path of the UE shown in FIG. 16. Data transmission Tx#1 in FIG. 17 corresponds to the location P1 in the moving path of the UE in FIG. 16.

As shown in FIG. 16, the UE is initially located in the sub-region #2, and the base station configures the CCB, the RSB #2 of the sub-region #2, and the RSB #4 of the adjacent sub-region #4 of the sub-region #2 for the UE.

When the UE moves to P1, the base station performs data transmission Tx#1. In this case, the UE is located at the boundary of the sub-region #2 and the sub-region #4. Based on the second processing manner, the base station may use the CCB and the RSB #2 of the sub-region #2 to perform projection compression on RF map data in the group A to obtain a compression result A, and may use the CCB and the RSB #4 of the sub-region #4 to perform projection compression on RF map data in the group B to obtain a compression result B. When the CCB is used to perform projection compression, projection compression on the group A and the group B may be completed at a time, that is, the base station uses the CCB to perform projection compression on the data (including the group A and the group B) to be sent to the UE to obtain a compression result and a residual, then uses the RSB #2 of the sub-region #2 to perform projection compression on a part that is in the residual and that corresponds to the group A to obtain the compression result A, and uses the RSB #4 of the sub-region #4 to perform projection compression on a part that is in the residual and that corresponds to the group B to obtain the compression result B. The base station may send, to the UE, a result of projection compression performed by using the CCB, the compression result A of projection compression performed by using the RSB #2, the RSB indication information #2, the compression result B of projection compression performed by using the RSB #4, the RSB indication information #4, and grouping indication information, where the RSB indication information #2 indicates the RSB #2, the RSB indication information #4 indicates the RSB #4, and the grouping indication information indicates whether grouping is performed. In FIG. 17, the group indication information indicates a group.

In addition, in some specific scenarios, when the foregoing overlapping grouping compression is used, the base station further needs to indicate a grouping status of the data to the UE, so that the UE recovers an original data sequence based on the grouping status of the data. For grouping into the group A and the group B mentioned above, the base station further needs to indicate, to the UE, which data is grouped into the group A and which data is grouped into the group B. The base station may further indicate the grouping status by using the grouping indication information. The grouping indication information may correspond to the ninth information in the method 500.

FIG. 18 is an example of data grouping. As shown in FIG. 18, the data to be sent to the UE includes data 0 to data 16. The data 0, 3, 4, 6, 9, and 12 are grouped into the group A, and the data 1, 2, 5, 7, 8, 10, 11, 13, 14, and 15 are grouped into the group B. In this case, the group indication information may indicate a group and a location of each piece of data in the original data. For example, the group indication information indicates a group and {0, 3, 4, 6, 9, 12}.

Manner 2: The projection basis is associated with an identity of the UE.

In Manner 2, the first layer in the two-layer structure of the projection bases is associated with a plurality of UEs, and the second layer is associated with one of the plurality of UEs. For ease of description, the second-layer projection basis in Manner 2 is referred to as a UE-specific projection basis (UE specific basis, USB). It should be noted that the CB is a group of projection bases, or the CB includes one or more projection bases. The USB is a group of projection bases, or the USB includes one or more projection bases. The plurality of UEs may correspond to the communication device group in the method 500, and the UE may correspond to the part of the communication devices in the method 500.

For example, the CB is associated with a user group, and the CB is a common projection basis of UEs in the user group. The USB is associated with a UE in the user group, that is, the USB is a projection basis used by the UE, and different USBs correspond to different UEs in the user group.

For a manner of determining the CB and the USB in Manner 2, refer to the manner of determining the CCB and the RSB in Manner 1. A difference is that the CB is obtained based on data of a plurality of UEs, and a USB of a UE is obtained based on data of the UE.

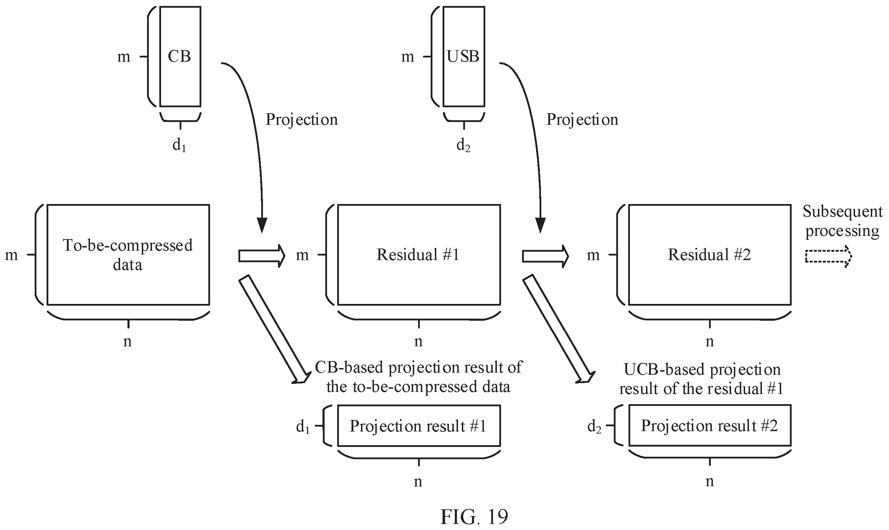

FIG. 19 is another diagram of an overall procedure of data compression based on two layers of projection bases.

When the base station needs to send data to a plurality of UEs, the base station may obtain a CB corresponding to the plurality of UEs and USBs respectively corresponding to the plurality of UEs, and the base station may use the CB and the USBs corresponding to the UEs to perform projection compression on the data to be sent to the UEs. Specifically, as shown in FIG. 19, the base station first uses the CB to perform projection compression on the to-be-compressed data to obtain a projection result #1 and a residual #1, and then uses the USB to further perform projection compression on the residual #1 to obtain a projection result #2 and a residual #2. Then, the base station sends the projection result #1 and the projection result #2 to the UE. Optionally, the base station may further send the residual #2 to the UE, or if further processing (for example, compression processing) is further performed on the residual #2 subsequently, the base station may further send a result of subsequent processing performed on the residual #2 to the UE.

A manner of configuring the CB and the USB is not limited in embodiments of this application.

In a possible implementation, the base station multicasts the CB to the plurality of UEs (namely, all target UEs), and the CB is sent only once. The base station may unicast, to each UE in the plurality of UEs, the USB corresponding to the UE. In this implementation, content multicast and unicast by the base station to the UE may be shown as follows:
multicast content: including the CB; and
unicast content: including a projection result of data of each UE in the plurality of UEs on the CB, the USB corresponding to each UE, and a result of further projection compression, on the USB, of a residual obtained through CB-based projection compression on the data of each UE.

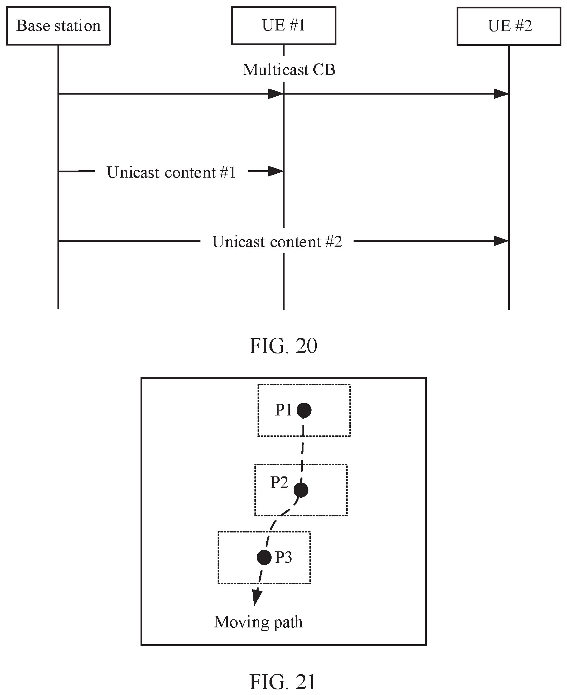

FIG. 20 is an example of the configuration of the CB and the USB and the data transmission. In FIG. 20, an example in which the base station sends data to the UE #1 and the UE #2 is used. As shown in FIG. 20, the base station multicasts a CB to the UE #1 and the UE #2, sends unicast content #1 to the UE #1, and sends unicast content #2 to the UE #2.

The unicast content #1 includes a projection result of data of the UE #1 on the CB, a projection result of a CB-based projection residual on a USB of the UE 1, and the USB of the UE 1.

The unicast content #2 includes a projection result of data of the UE #2 on the CB, a projection result of a CB-based projection residual on a USB of the UE 2, and the USB of the UE 2.

It should be noted that the projection result on the CB, the projection result of the CB-based projection residual on the USB of the UE, and the USB of the UE that are included in the unicast content may be carried in same signaling or may be carried in different signaling. This is not limited.

The following uses performance of RSB-based projection compression as an example to describe beneficial effects of embodiments of this application with reference to a simulation result.

FIG. 21 is a diagram of a simulation scenario. An implementation block in FIG. 21 is an entire sub-region, and an RSB of the sub-region is configured for the UE. The UE moves based on a dashed line with an arrow. At locations P1, P2, and P3, the base station sequentially sends RF map data to the UE. At P1, the base station sends RF map data in a dashed line box at P1; at P2, sends RF map data in a dashed line box at P2; and at P3, sends RF map data in a dashed line box at P3.

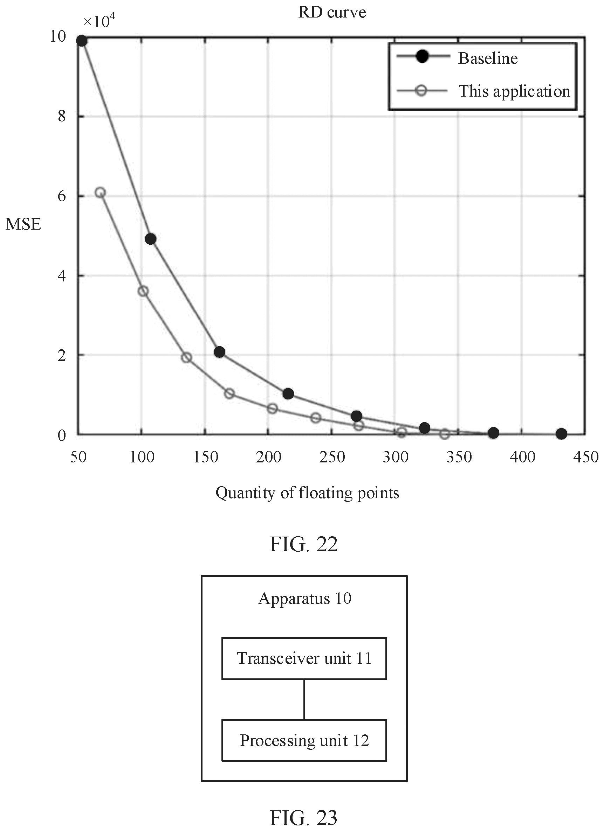

FIG. 22 is a diagram of comparison of RD performance of compression.

A horizontal coordinate indicates a quantity of floating points (floating points, FPs), and a vertical coordinate indicates a mean square error (mean square error, MSE).

Baseline (Baseline): LRMA compression is independently performed on data sent in three times, a compression rate is adjusted by adjusting a rank (rank) parameter of LRMA, and total data amount overheads and a total MSE of the three times of data transmission are calculated.

In this application, the RSB of the sub-region is separately used to perform projection compression on the data sent in three times, and the total data amount overheads and the total MSE of the three times of data transmission are calculated. In this application, because the RSB is configured only once (the UE keeps moving in the sub-region), overheads of the RSB are calculated only once.

It can be learned from FIG. 22 that RD performance of the solution provided in this application is better than RD performance of the solution in which compression is performed by using LRMA independently.

The foregoing describes in detail the method embodiments provided in this application with reference to FIG. 1 to FIG. 22. The following describes apparatus embodiments of this application with reference to FIG. 23 to FIG. 25.

It may be understood that, to implement functions in the foregoing embodiments, apparatuses in FIG. 23 to FIG. 25 include corresponding hardware structures and/or software modules for performing the functions. A person skilled in the art should be easily aware that, in this application, the units and method steps in the examples described with reference to embodiments disclosed in this application can be implemented by hardware or a combination of hardware and computer software.

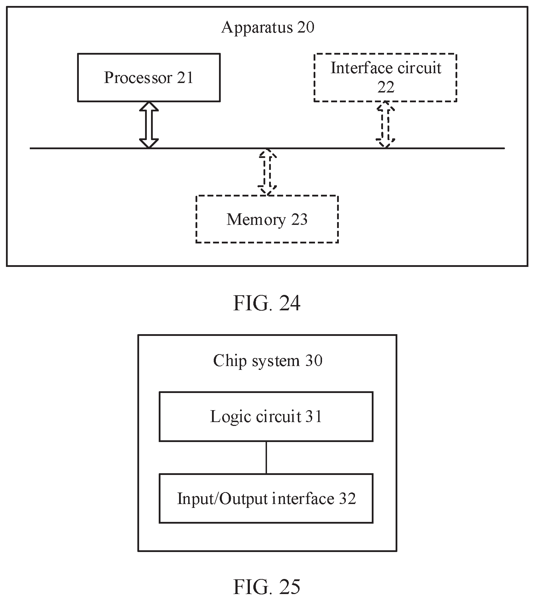

FIG. 23 and FIG. 24 are diagrams of structures of possible apparatuses according to embodiments of this application. These apparatuses may be configured to implement functions of the first communication device or the second communication device in the foregoing method embodiments, and therefore may also implement beneficial effects of the foregoing method embodiments.

As shown in FIG. 23, an apparatus 10 includes a transceiver unit 11 and a processing unit 12.

When the apparatus 10 is configured to implement the functions of the first communication device in the foregoing method embodiments, the transceiver unit 11 is configured to perform sending and receiving steps of the first communication device, and the processing unit 12 is configured to perform processing steps of the first communication device. When the apparatus 10 is configured to implement the functions of the second communication device in the foregoing method embodiments, the transceiver unit 11 is configured to perform sending and receiving steps of the second communication device, and the processing unit 12 is configured to perform processing steps of the second communication device.

For more detailed descriptions of the transceiver unit 11 and the processing unit 12, refer to the related descriptions in the foregoing method embodiments. Details are not described herein again.

As shown in FIG. 24, an apparatus 20 includes a processor 21. The processor 21 is coupled to a memory 23. The memory 23 is configured to store instructions. When the apparatus 20 is configured to implement the foregoing method, the processor 21 is configured to execute the instructions in the memory 23, to implement a function of the processing unit 12.

Optionally, the apparatus 20 further includes the memory 23.

Optionally, the memory (for example, 23) in this embodiment of this application may be integrated into the processor (for example, 21).

Optionally, the apparatus 20 further includes an interface circuit 22. The interface circuit may be referred to as a communication interface. The processor 21 and the interface circuit 22 are coupled to each other. It may be understood that the interface circuit 22 may be a transceiver or an input/output interface. When the apparatus 20 is configured to implement the foregoing method, the processor 21 is configured to execute the instructions to implement the functions of the processing unit 12, and the interface circuit 22 is configured to implement functions of the transceiver unit 11. The interface circuit may also be referred to as a transceiver circuit.

Optionally, the apparatus 20 may be the first communication device or the second communication device, and correspondingly, the interface circuit may be a transceiver.

Optionally, the apparatus 20 may be a chip used in the first communication device or the second communication device. Correspondingly, the interface circuit may be an input/output interface.

For example, when the apparatus 20 is a chip used in the first communication device or the second communication device, the chip implements functions of the first communication device or the second communication device in the foregoing method embodiments. The chip receives information from another module (for example, a radio frequency module or an antenna) in the first communication device or the second communication device, where the information is sent by another apparatus to the first communication device or the second communication device; or the chip sends information to another module (for example, a radio frequency module or an antenna) in the first communication device or the second communication device, where the information is sent by the first communication device or the second communication device to the another apparatus.

FIG. 25 is a diagram of a chip system 30 according to an embodiment of this application. The chip system 30 (or may be referred to as a processing system) includes a logic circuit 31 and an input/output interface (input/output interface) 32.

The logic circuit 31 may be a processing circuit in the chip system 30. The logic circuit 31 may be coupled and connected to a storage unit, and invoke instructions in the storage unit, to enable the chip system 30 to implement the methods and the functions in embodiments of this application. The input/output interface 32 may be an input/output circuit in the chip system 30, and outputs information processed by the chip system 30, or inputs to-be-processed data or signaling information to the chip system 30 for processing.

In a solution, the chip system 30 is configured to implement operations performed by the first communication device and the second communication device in the foregoing method embodiments.

For example, the logic circuit 31 is configured to implement a processing-related operation performed by the first communication device or the second communication device in the foregoing method embodiments, and the input/output interface 32 is configured to implement a sending-related operation and/or a receiving-related operation performed by the first communication device or the second communication device in the foregoing method embodiments.

This application further provides a communication apparatus, including a processing circuit. The processing circuit is coupled to a memory. The memory is configured to store a computer program or instructions and/or data. The processing circuit is configured to execute the computer program or the instructions stored in the memory, or read the data stored in the memory, to perform the method in the foregoing method embodiments. Optionally, there are one or more processing circuits. Optionally, the communication apparatus includes the memory. Optionally, there are one or more memories. Optionally, the memory and the processing circuit are integrated together or disposed separately.

This application further provides a chip, including a processing circuit. The processing circuit is coupled to a memory. The memory is configured to store a computer program or instructions. The processing circuit is configured to execute the computer program or the instructions stored in the memory, to implement the method performed by the first communication device or the second communication device in the foregoing method embodiments. The memory may be located in the chip, or may be independent of the chip and located outside the chip. This is not limited herein.

This application further provides a computer-readable storage medium. The computer-readable storage medium stores computer instructions used to implement the method performed by the first communication device or the second communication device in the foregoing method embodiments.

This application further provides a computer program product, including instructions. When the instructions are executed by a computer, the method performed by the first communication device or the second communication device in the foregoing method embodiments is implemented.

This application further provides a communication system. The communication system includes at least one of the first communication device or the second communication device in the foregoing embodiments.

For explanations and beneficial effects of related content in any one of the apparatuses provided above, refer to the corresponding method embodiment provided above. Details are not described herein again.

It may be understood that the processing circuit in embodiments of this application may be a processor or a circuit configured to perform a processing operation in a processor. The processor may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any conventional processor.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk drive, a removable hard disk drive, a compact disc read-only memory (compact disc read-only memory, CD-ROM), or any other form of storage medium well-known in the art. For example, a storage medium is coupled to the processor, so that the processor can read information from the storage medium and write information into the storage medium. Certainly, the storage medium may be a component of the processor. The processor and the storage medium may be disposed in an ASIC. In addition, the ASIC may be located in the first communication device or the second communication device. Certainly, the processor and the storage medium may exist in the first communication device or the second communication device as discrete components.

All or some of the foregoing embodiments may be implemented by using software, hardware, firmware, or any combination thereof. When software is used to implement the embodiments, all or some of the embodiments may be implemented in a form of a computer program product. The computer program product includes one or more computer programs or instructions. When the computer programs or instructions are loaded and executed on a computer, the procedures or functions in embodiments of this application are all or partially executed. The computer may be a general-purpose computer, a dedicated computer, a computer network, a network device, user equipment, or another programmable apparatus. The computer program or instructions may be stored in a computer-readable storage medium, or may be transmitted from a computer-readable storage medium to another computer-readable storage medium. For example, the computer program or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive.

In embodiments of this application, unless otherwise stated or there is a logic conflict, terms and/or descriptions of different embodiments are consistent and may be mutually referenced, and technical features in different embodiments may be combined into a new embodiment based on an internal logical relationship thereof.

Unless otherwise stated, meanings of all technical and scientific terms used in embodiments of this application are the same as those usually understood by a person skilled in the technical field of this application. The terms used in this application are merely intended to describe objectives of the specific embodiments, and are not intended to limit the scope of this application. It should be understood that the foregoing is an example for description, and the foregoing examples are merely intended to help a person skilled in the art understand embodiments of this application, but are not intended to limit embodiments of this application to examples of specific values or specific scenarios.

## Claims

1. A data transmission method, wherein the method is applied to a first communication device, and the method comprises:
obtaining data to be sent to a second communication device, wherein the data to be sent to the second communication device comprises first data;
obtaining a first projection basis group and a second projection basis group, wherein a projection basis in the first projection basis group corresponds to a first range, a projection basis in the second projection basis group corresponds to a second range, the second range is a sub-range of the first range, and the first data corresponds to the second range;
compressing the first data based on the first projection basis group to obtain a first projection result and a first residual;
compressing the first residual based on the second projection basis group to obtain a second projection result; and
sending compressed data to the second communication device, wherein the compressed data comprises the first projection result and the second projection result.

2. The method according to claim 1, wherein
the first range is a first region, and the second range is a second region; or
the first range corresponds to a communication device group, and the second range corresponds to a part of communication devices in the communication device group.

3. The method according to claim 1 or 2, wherein the method further comprises:
sending first information and/or second information to the second communication device, wherein
the first information indicates one or more projection bases that are in the first projection basis group and that are used to compress the first data, and the second information indicates one or more projection bases that are in the second projection basis group and that are used to compress the first residual.

4. The method according to any one of claims 1 to 3, wherein
the compressed data further comprises a second residual, and the second residual is a residual obtained when the first residual is compressed based on the second projection basis group or a subsequent processing result of the residual obtained when the first residual is compressed based on the second projection basis group.

5. The method according to any one of claims 1 to 4, wherein
the compressed data further comprises a third projection result;
the method further comprises: obtaining a third projection basis group, wherein a projection basis in the third projection basis group corresponds to a third range, and the third range is a sub-range of the second range;
compressing the first residual based on the second projection basis group to obtain the second projection result comprises: compressing the first residual based on the second projection basis group to obtain the second projection result and a third residual; and
the method further comprises: compressing the third residual based on the third projection basis group to obtain the third projection result.

6. The method according to any one of claims 1 to 5, wherein the method further comprises:
determining the first projection basis group based on second data corresponding to the first range; and
determining the second projection basis group based on third data corresponding to the second range.

7. The method according to claim 6, wherein determining the second projection basis group based on the third data corresponding to the second range comprises:
compressing the third data based on the first projection basis group to obtain the second residual; and
determining the second projection basis group based on the second residual.

8. The method according to claim 6 or 7, wherein the method further comprises:
sending the first projection basis group and/or the second projection basis group to the second communication device.

9. The method according to claim 8, wherein
the first range is the first region, and the second range is the second region; and
sending the first projection basis group and/or the second projection basis group to the second communication device comprises:
after the second communication device enters the first region, sending the first projection basis group to the second communication device; and/or
after the second communication device enters the second region, sending the second projection basis group to the second communication device.

10. The method according to claim 8, wherein
the first range is the first region, and the second range is the second region; and
sending the first projection basis group and/or the second projection basis group to the second communication device comprises: sending third information and/or fourth information to the second communication device, wherein
the third information indicates a first set, the first set comprises a plurality of projection basis groups, the plurality of projection basis groups respectively correspond to a plurality of sub-regions of a third region, and the plurality of sub-regions of the third region comprise the first region; and
the fourth information indicates a second set, the second set comprises a plurality of projection basis groups, the plurality of projection basis groups respectively correspond to a plurality of sub-regions of the first region, and the plurality of sub-regions of the first region comprise the second region.

11. The method according to claim 10, wherein the method further comprises:
sending fifth information and/or sixth information to the second communication device, wherein
the fifth information indicates that the first projection result corresponds to the first projection basis group, and the sixth information indicates that the second projection result corresponds to the second projection basis group.

12. The method according to claim 10, wherein the method further comprises:
sending seventh information and/or eighth information to the second communication device, wherein
the seventh information indicates a correspondence between the plurality of projection basis groups comprised in the first set and the plurality of sub-regions of the third region, and the eighth information indicates a correspondence between the plurality of projection basis groups comprised in the second set and the plurality of sub-regions of the first region.

13. The method according to any one of claims 1 to 12, wherein
the first range is the first region, and the second range is the second region; and
obtaining the first projection basis group and the second projection basis group comprises: obtaining location information of the first communication device or the second communication device; and obtaining, based on the location information, the first projection basis group corresponding to the first region in which the first communication device or the second communication device is located and the second projection basis group corresponding to the second region in which the first communication device or the second communication device is located.

14. The method according to any one of claims 1 to 13, wherein
the first range is the first region, and the second range is the second region;
the data to be sent to the second communication device further comprises fourth data, the fourth data corresponds to a fourth region, the fourth region is a sub-region of the first region, and the compressed data further comprises a fourth projection result corresponding to the fourth data;
the method further comprises: obtaining a fourth projection basis group, wherein a projection basis in the fourth projection basis group corresponds to the fourth region;
compressing the first data based on the first projection basis group to obtain the first projection result and the first residual comprises: compressing the first data and the fourth data based on the first projection basis group to obtain the first projection result and the first residual, wherein the first residual comprises a first sub-part and a second sub-part;
compressing the first residual based on the second projection basis group to obtain the second projection result comprises: compressing the first sub-part of the first residual based on the second projection basis group to obtain the second projection result; and
the method further comprises: compressing the second sub-part of the first residual based on the fourth projection basis group to obtain the fourth projection result.

15. The method according to claim 14, wherein the method further comprises:
sending ninth information to the second communication device, wherein the ninth information indicates a location of the first data and/or a location of the fourth data in the data to be sent to the second communication device.

16. The method according to any one of claims 1 to 5, wherein
the first range is the first region, and the second range is the second region; and
obtaining the first projection basis group and the second projection basis group comprises: receiving the first projection basis group and the second projection basis group from the second communication device.

17. The method according to claim 16, wherein the method further comprises:
receiving tenth information and/or eleventh information from the second communication device, wherein
the tenth information indicates a correspondence between the first projection basis group and the first region, and the eleventh information indicates a correspondence between the second projection basis group and the second region.

18. The method according to any one of claims 2 to 17, wherein the first region is a cell.

19. The method according to any one of claims 1 to 8, wherein
the first range corresponds to the communication device group, and the second range corresponds to the part of the communication devices in the communication device group; and
obtaining the first projection basis group and the second projection basis group comprises: obtaining, based on the second communication device belonging to the communication device group, the first projection basis group corresponding to the communication device group; and obtaining, based on the second communication device belonging to the part of the communication devices, the second projection basis group corresponding to the part of the communication devices.

20. The method according to claim 8, wherein
the first range corresponds to the communication device group, and the second range corresponds to the second communication device in the communication device group; and
sending the first projection basis group and/or the second projection basis group to a communication device in the communication device group comprises: multicasting the first projection basis group to communication devices in the communication device group, and/or unicasting the second projection basis group to the second communication device.

21. A data transmission method, wherein the method is applied to a second communication device, and the method comprises:
receiving compressed data from a first communication device, wherein the compressed data comprises a first projection result and a second projection result;
obtaining a first projection basis group and a second projection basis group, wherein a projection basis in the first projection basis group corresponds to a first range, a projection basis in the second projection basis group corresponds to a second range, and the second range is a sub-range of the first range;
performing decompression based on the second projection basis group and the second projection result to obtain a first residual; and
performing decompression based on the first projection basis group and the first residual to obtain first data.

22. The method according to claim 21, wherein
the first range is a first region, and the second range is a second region; or
the first range corresponds to a communication device group, and the second range corresponds to a part of communication devices in the communication device group.

23. The method according to claim 21 or 22, wherein the method further comprises:
receiving first information and/or second information from the first communication device, wherein
the first information indicates one or more projection bases that are in the first projection basis group and that are used to compress the first data, and the second information indicates one or more projection bases that are in the second projection basis group and that are used to compress the first residual.

24. The method according to any one of claims 21 to 23, wherein
the compressed data further comprises a second residual; and
performing decompression based on the second projection basis group and the second projection result to obtain the first residual comprises: performing decompression based on the second projection basis group, the second projection result, and the second residual to obtain the first residual.

25. The method according to any one of claims 21 to 24, wherein
the compressed data further comprises a third projection result;
the method further comprises: obtaining a third projection basis group, wherein a projection basis in the third projection basis group corresponds to a third range, and the third range is a sub-range of the second range; and performing decompression based on the third projection basis group and the third projection result to obtain a third residual; and
performing decompression based on the second projection basis group and the second projection result to obtain the first residual comprises: performing decompression based on the second projection basis group, the second projection result, and the third residual to obtain the first residual.

26. The method according to any one of claims 21 to 25, wherein obtaining the first projection basis group and the second projection basis group comprises:
receiving the first projection basis group and the second projection basis group from the first communication device.

27. The method according to claim 26, wherein
the first range is the first region, and the second range is the second region; and
receiving the first projection basis group and the second projection basis group from the first communication device comprises: after the second communication device enters the first region, receiving the first projection basis group from the first communication device; and after the second communication device enters the second region, receiving the second projection basis group from the first communication device.

28. The method according to claim 26, wherein
the first range corresponds to the communication device group, and the second range corresponds to the second communication device in the communication device group; and
receiving the first projection basis group and the second projection basis group from the first communication device comprises: receiving the first projection basis group that is multicast by the first communication device; and receiving the second projection basis group that is unicast by the first communication device.

29. The method according to any one of claims 21 to 25, wherein
the first range is the first region, and the second range is the second region;
the method further comprises: receiving third information and fifth information from the first communication device, wherein the third information indicates a first set, the first set comprises a plurality of projection basis groups, the plurality of projection basis groups respectively correspond to a plurality of sub-regions of a third region, the plurality of sub-regions of the third region comprise the first region, and the fifth information indicates that the first projection result corresponds to the first projection basis group; and
obtaining the first projection basis group comprises: obtaining the first projection basis group from the first set based on the third information;
and/or
the method further comprises: receiving fourth information and sixth information from the first communication device, wherein the fourth information indicates a second set, the second set comprises a plurality of projection basis groups, the plurality of projection basis groups respectively correspond to a plurality of sub-regions of the first region, the plurality of sub-regions of the first region comprise the second region, and the sixth information indicates that the second projection result corresponds to the second projection basis group; and
obtaining the second projection basis group comprises: obtaining the second projection basis group from the second set based on the fourth information.

30. The method according to any one of claims 21 to 25, wherein
the first range is the first region, and the second range is the second region;
the method further comprises: obtaining location information of the first communication device or the second communication device; and
the method further comprises: receiving third information and seventh information from the first communication device, wherein the third information indicates a first set, the first set comprises a plurality of projection basis groups, the plurality of projection basis groups respectively correspond to a plurality of sub-regions of a third region, the plurality of sub-regions of the third region comprise the first region, and the seventh information indicates a correspondence between the plurality of projection basis groups comprised in the first set and the plurality of sub-regions of the third region; and
obtaining the first projection basis group comprises: obtaining, from the first set based on the location information, the third information, and the seventh information, the first projection basis group corresponding to the first region in which the first communication device or the second communication device is located;
and/or
the method further comprises: receiving fourth information and eighth information from the first communication device, wherein the fourth information indicates a second set, the second set comprises a plurality of projection basis groups, the plurality of projection basis groups respectively correspond to a plurality of sub-regions of the first region, the plurality of sub-regions of the first region comprise the second region, and the eighth information indicates a correspondence between the plurality of projection basis groups comprised in the second set and the plurality of sub-regions of the first region; and
obtaining the second projection basis group comprises: obtaining, from the second set based on the location information, the fourth information, and the eighth information, the second projection basis group corresponding to the second region in which the first communication device or the second communication device is located.

31. The method according to any one of claims 21 to 30, wherein
the first range is the first region, and the second range is the second region;
the compressed data further comprises a fourth projection result;
performing decompression based on the second projection basis group and the second projection result to obtain the first residual comprises: performing decompression based on the second projection basis group and the second projection result to obtain a first sub-part of the first residual;
the method further comprises: obtaining a fourth projection basis group, wherein a projection basis in the fourth projection basis group corresponds to a fourth region, and the fourth region is a sub-region of the first region; and performing decompression based on the fourth projection basis group and the fourth projection result to obtain a second sub-part of the first residual; and
performing decompression based on the first projection basis group and the first residual to obtain the first data comprises: performing decompression based on the first projection basis group, the first sub-part of the first residual, and the second sub-part of the first residual to obtain the first data.

32. The method according to claim 31, wherein the method further comprises:
receiving ninth information from the first communication device, wherein the ninth information indicates a location of the first data and/or a location of fourth data in data to be sent to the second communication device, and the fourth data corresponds to a fourth region.

33. The method according to any one of claims 21 to 25, wherein
the first range is the first region, and the second range is the second region; and
obtaining the first projection basis group and the second projection basis group comprises: determining the first projection basis group based on second data corresponding to the first region; and determining the second projection basis group based on third data corresponding to the second region.

34. The method according to claim 33, wherein the method further comprises:
sending tenth information and/or eleventh information to the first communication device, wherein
the tenth information indicates a correspondence between the first projection basis group and the first region, and the eleventh information indicates a correspondence between the second projection basis group and the second region.

35. The method according to any one of claims 22 to 34, wherein the first region is a cell.

36. A communication apparatus, comprising a module or a unit configured to perform the method according to any one of claims 1 to 35.

37. A communication apparatus, comprising a processor and an interface circuit, wherein the interface circuit is configured to: receive a signal from a communication apparatus other than the communication apparatus and transmit the signal to the processor, or send a signal from the processor to a communication apparatus other than the communication apparatus; and the processor is configured to implement the method according to any one of claims 1 to 35 by using a logic circuit or executing code instructions.

38. The communication apparatus according to claim 37, wherein the communication apparatus is a chip or a chip system.

39. A computer-readable storage medium, wherein the storage medium stores a computer program or instructions, and when the computer program or the instructions are executed by a communication apparatus, the method according to any one of claims 1 to 35 is implemented.

40. A computer program product, comprising a computer program, wherein when the computer program is run, the method according to any one of claims 1 to 35 is implemented.

41. A communication system, comprising:
a communication apparatus configured to perform the method according to any one of claims 1 to 20; and
a communication apparatus configured to perform the method according to any one of claims 21 to 35.
